# EUROPÄISCHE PATENTANMELDUNG

(11) **EP 2 759 514 A1**
(43) Veröffentlichungstag der Anmeldung: **30.07.2014**
(21) Anmeldenummer: 13152987.7
(22) Anmeldetag: 29.01.2013
(51) Int. Cl.: B82Y 40/00, C09J 7/02, C09J 153/02, H01L 51/52

(54) **Haftklebemasse enthaltend ein verbundenes Nanopartikelnetzwerk, Verfahren zu ihrer Herstellung sowie die Verwendung derselben**

(71) Anmelder: tesa SE, 20253 Hamburg (DE)
(72) Erfinder: Bai, Minyoung, 22529 Hamburg (DE); Dollase, Thilo, 22397 Hamburg (DE); Keite-Telgenbüscher, Dr. Klaus, 22529 Hamburg (DE); Krawinkel, Thorsten, 22457 Hamburg (DE); Schuh, Christian, 22767 Hamburg (DE); Lühmann, Dr. Bernd, 22844 Norderstedt (DE)

(57) **Zusammenfassung**

Haftklebemasse, umfassend mindestens zwei jeweils eine Phase bildende Bestandteile, aus denen durch insbesondere vernetzende Aufbaureaktion ein IPN mit mindestens zwei Phasen entsteht, wobei die erste Phase (Elastomerphase) zumindest eine Erweichungstemperatur nach DSC von kleiner 23 °C und die zweite Phase nach der Aufbaureaktion eine Erweichungstemperatur nach DSC von größer 23 °C aufweist, wobei die zweite Phase nach der Aufbaureaktion die Morphologie eines verbundenen Nanopartikelnetzwerks aufweist.

## Beschreibung

Die vorliegende Erfindung betrifft eine Haftklebemasse enthaltend ein verbundenes Nanopartikelnetzwerk, Verfahren zu ihrer Herstellung sowie die Verwendung derselben insbesondere für die Kapselung einer elektronischen Anordnung.

Haftklebstoffe (PSAs) werden in einer Vielzahl von Anwendungen eingesetzt, da sie viele erwünschte charakteristische Merkmale bieten wie zum Beispiel die Entfernbarkeit und die leichte Anwendung. Für eine dauerhaftere und eine sehr glatte Klebung haben einige konventionelle PSAs eine nicht unbedingt ausreichende Festigkeit, um ihre Haftung an bestimmten Substraten zu bewahren und aufrechtzuerhalten. Ferner ist möglicherweise ein konventioneller PSA beim Auftragen auf bestimmte Materialien nicht in der Lage, der Einwirkung von erhöhten Temperaturen oder hoher Feuchtigkeit zu widerstehen. Die Anwendung eines PSAs zum Beispiel auf Acryltafeln und Polycarbonattafeln, die bekanntermaßen "Materialien ausgasen" und schwierig zu kleben sind, kann zu Blasenbildung und Delaminierung führen.

Härtbare Klebstoffe (zum Beispiel wärme- oder lichtgehärtete) werden in Anwendungen eingesetzt, bei denen Substrate eine erhebliche Beständigkeit und hochfeste Haftung erfordern. Konventionelle härtbare Klebstoffe werden jedoch normalerweise nicht als PSA und auch nicht in der Form bereitgestellt, die leicht anzuwenden ist, wie zum Beispiel als Band.

Für optische Produktanwendungen (zum Beispiel Verglasungen) sind härtbare Klebstoffe wünschenswert, da sie für optisch klare, stark haftende Laminate (zum Beispiel geschichtete Substrate) sorgen.

Um sowohl Festigkeit und leichte Anwendbarkeit zu erreichen, sind hybride Zusammensetzungen entwickelt worden.

Konventionelle härtbare Klebstoffe enthalten reaktive chemische Grundbausteine wie beispielsweise Epoxidklebstoffe, die Epoxidgruppen enthalten. Bei der Härtung können sich diese Grundbausteine mit Hilfe eines Härters über die Epoxidgruppen miteinander verbinden und ein stabiles, dreidimensionales Netzwerk ausbilden. Diese Netzwerkbildung ist eine wesentliche Ursache für die allgemein hohen Festigkeiten und guten Klebeigenschaften von Epoxidklebstoffen auf vielen Materialien.

Hybride Zusammensetzungen zeichnen sich durch das Einbinden weiterer Materialien in diese Netzwerkstruktur aus. Lösungsansätze sind vor allem die Herstellung von Interpenetrierenden Netzwerken (IPN) oder anderen mehrphasigen Strukturen.

IPNs sind definiert als Kombination zweier Polymere in Netzwerkform, von denen zumindest eines in unmittelbarer Gegenwart des anderen vernetzt beziehungsweise polymerisiert wurde (siehe "Interpenetrating Polymer Networks", in "Encyclopedia of Polymer Science and Engineering", Vol. 10, Seiten 272 bis 311, Published Online: 15 MAR 2004, DOI: 10.1002/0471440264.pst170, John Wiley & Sons, Inc.).

Dabei bildet jedes Polymer ein gesondertes Netzwerk und beide Netzwerke liegen nebeneinander vor. Es handelt sich also um ein zweiphasiges System. Kovalente Bindungen zwischen ihnen fehlen. Solche Netzwerke mit gegenseitiger Durchdringung sind sequentiell (aus Polymer A und Monomer B) oder simultan (aus Monomer A und Monomer B) hergestellt worden. Vorzugsweise kombiniert man ein Elastomer und ein Glas, zum Beispiel ein Polyurethan und ein Polymethacrylat. Je nach den Mengenverhältnissen entsteht ein verstärktes Elastomer oder ein Harz von hoher Schlagzähigkeit.

IPN-Systeme können chemisch sehr verschieden zusammengesetzt sein. Für ihre Synthese gibt es im Wesentlichen zwei Techniken:

Die simultane Technik besteht darin, zwei lineare Polymere, Präpolymere oder Monomere der Sorten A und B mit den jeweiligen Vernetzungsagentien im flüssigen Zustand, also in Masse, Schmelze, Lösung oder Dispersion, zusammenzugeben und simultan zu polymerisieren beziehungsweise zu vernetzen. Dabei müssen Substanzen ausgewählt werden, die nicht miteinander reagieren.

Die sequenzielle Technik besteht darin, ein vernetztes Polymer A mit einem Monomer der Sorte B zu quellen und letzteres dann in situ unter Zugabe von Vernetzungsagentien zu polymerisieren beziehungsweise zu vernetzten.

Zwischen den beiden Polymerkonstituenten in IPNs bestehen im Wesentlichen keine und insbesondere keine kovalenten Bindungen.

Unterschieden wird zwischen semi-interpenetrierenden Netzwerken und vollständig interpenetrierenden Netzwerken. Die oben beschriebenen Methoden führen zu vollständig interpenetrierenden Netzwerken.

Unter einem semi-interpenetrierenden Netzwerk wird die Kombination eines linearen unvernetzten Polymers und eines ersten vernetzten Polymers verstanden, wobei das erste vernetzte Polymer in Gegenwart des anderen synthetisiert ist. Das unvernetzte Polymer durchdringt das Netzwerk des vernetzten Polymers und bewirkt, dass die beiden Komponenten infolge von Verhakungen und Verschlaufungen physikalisch kaum trennbar sind. Dieses semi-interpenetrierende Netzwerk ermöglicht die Eigenschaftskombination zweier Polymere, selbst wenn sie thermodynamisch unverträglich sind.

IPN-Systeme sind Beispiele für Polymermischungen, bei denen eine makroskopische Phasentrennung nicht in Erscheinung tritt.
Normalerweise führt das Mischen von Polymeren zu mehrphasigen Systemen, welches auf die wohlbekannte thermodynamische Unverträglichkeit der meisten Polymeren zurückzuführen ist. Diese Inkompatibilität resultiert aus dem relativ niedrigen Entropiegewinn beim Mischen von Polymeren, der seinerseits darauf beruht, dass die große Länge der Ketten ihre Möglichkeiten zur Berührung einschränkt. Werden jedoch Produkte mit niedrigerem Molekulargewicht gemischt und anschließend simultan polymerisiert und vernetzt, so kann eine kinetische Kontrolle der Phasentrennung erreicht werden.

In bisher synthetisierten IPN-Systemen findet man ein unterschiedliches Ausmaß an Phasentrennung, hauptsächlich in Abhängigkeit von der Verträglichkeit der Polymere. Bei besonders unverträglichen Polymeren überwiegt die thermodynamisch bedingte Phasentrennung so stark, dass sie im Wesentlichen schon abgelaufen ist, ehe sie durch die kinetisch bedingten Veränderungen (das heißt die Vernetzung) verhindert werden kann. In diesen Fällen mischen sich die Phasen nur wenig.
Sind die Polymere besser verträglich, so kann die Phasentrennung fast vollständig umgangen werden. Hierbei ist zu beachten, dass eine vollständige Verträglichkeit (die äußerst selten auftritt) für eine vollständige Phasenmischung, also gegenseitige Durchdringung, nicht notwendig ist, da die durch die gegenseitige Durchdringung hervorgerufene "permanente" Verknäulung die Phasentrennung verhindert. Bei mittleren Verträglichkeiten wird das Phasenverhalten (die entstehende Morphologie) komplex; es resultieren Zwischenstufen.
Demgemäß gibt es IPN-Systeme mit Domänen dispergierter Phasen, die von einigen Mikrometern bis zu einigen hundert Angstrom reichen, und Systeme mit nicht mehr auflösbaren Domänenstrukturen (vollständige Mischung). Daher weisen wenig phasenseparierte IPNs in der Regel nur eine Glasübergangstemperatur auf.

Gegenüber gewöhnlichen Polymerblends zeichnen sich interpenetrierende Netzwerke durch bessere Beständigkeit gegenüber Entmischung und oft vorteilhaften mechanischen Eigenschaften aus. Die Abbaubeständigkeit der interpenetrierenden Netzwerke ist gewöhnlich besser als die von Copolymeren, in denen die unverträglichen Polymere als Blöcke kovalent miteinander verbunden sind. Daher werden IPNs auch im Bereich der Klebstoffe eingesetzt, wie es beispielsweise in der US 4,302,553 A beschrieben ist.

Bekannt sind Epoxidharzklebstoffe, die zusätzlich eine weitere Art von Grundbausteinen enthalten, die über einen zweiten chemischen Mechanismus ein eigenständiges Netzwerk ausbilden und nicht mit den epoxidhaltigen Bausteinen reagieren können. Bei der Härtung dieser Klebstoffe entstehen deshalb zwei voneinander unabhängige Klebstoffnetzwerke, die sich gegenseitig durchdringen, also IPNs. Praktisch gesehen bestehen solche Systeme aus zwei Klebstoffen in einem System, deren Eigenschaften sich im Idealfall synergistisch ergänzen.

Epoxidharze sind im Allgemeinen nur schlecht mit anderen Polymeren mischbar. Wird die Mischung trotzdem versucht, so neigen Polymere in der Regel zur Trennung der eingesetzten Phasen. Wenn es jedoch gelingt, bereits die unvernetzten beziehungsweise nicht polymerisierten Grundbausteine der Polymere zu vermischen und anschließend ihre Polymerisation so zu führen, dass die Phasentrennung der gebildeten Polymere verhindert wird, dann können im resultierenden Polymergemisch Synergieeffekte beobachtet werden. Für Eigenschaften wie die Klebfestigkeit oder Schlagzähigkeit ergeben sich oft deutlich höhere Werte als für die getrennt untersuchten Einzelnetzwerke (zum Beispiel reine Epoxidklebstoffe).

Der Effekt der Technologie der IPN-Modifizierung von Klebstoffen besteht daher in der Nutzung von Synergieeffekten, die sich nur in der Kombination zweier Netzwerke zeigen, aber nicht in den Einzelnetzwerken zu beobachten sind. Daraus resultieren häufig eine Maximierung von gewünschten Eigenschaften und eine mögliche Minimierung unerwünschter Eigenschaften.

IPNs sind auch aus dem Bereich der Haftklebemassen bekannt.

EP 0 621 931 B1 (DE 692 21 324 T2) beschreibt Hybridklebstoffe, die aus Acrylat- und Epoxidmonomeren hergestellt werden und somit ein simultanes IPN ausbilden. Ein Haftklebstoff kann nur erhalten werden, wenn die Reaktion zum Halten kommt, bevor die vollständige Aushärtung erfolgt ist (B-Zustand). In diesem Zustand muss der Haftklebefilm in der Regel gekühlt gelagert werden. Die Komponenten sind in der Mischung wenig verträglich miteinander, die resultierenden Klebstofffilme sind nach dem Härten vielfach opak, was auf die Ausbildung größerer Domänen hinweist. (Beispiele 9 bis 12).

WO 2004/060946 A1 (DE 603 06 961 T2) beschreibt eine Klebstoffzusammensetzung, die ein Acrylatcopolymer, acrylierte Oligomere und einen Initiator, der die radikalische Polymerisation startet, enthält. Es bildet sich ein Semi-IPN, welches zu einer hochtransparenten Klebemasse führt und auf eine geringe Phasenseparation schließen lässt. Dafür ist eine gute Verträglichkeit der Komponenten Voraussetzung. Diese wird durch die Kombination von Acrylatcopolymeren mit Acrylatoligomeren erreicht. Nachteilig ist, dass hierbei ähnliche Stoffklassen miteinander kombiniert werden, so dass die Bandbreite der erreichbaren synergistischen Effekte geringer ist als bei unterschiedlichen Stoffklassen.

US 5,747,567 A offenbart Semi-IPNs durch Mischung von Haftklebemassen auf der Basis von Natur- und Synthesekautschuken sowie Acrylaten mit den Komponenten einer silikonbasierten Haftklebemasse (Silikon-Harze, zum Beispiel MO-Harze, und Silikonfluide), wobei letztere in Gegenwart der Ersteren mittels einer Kondensationsreaktion zu einer Silikonhaftklebemasse vernetzen. Wiewohl die Möglichkeit der Herstellung solcher IPNs aus Lösung oder Emulsion genannt wird, wird in den Beispielen nur die Mischung auf Emulsionsebene offenbart. Da hier bereits vorliegende diskrete Phasen miteinander gemischt werden, liegt also ein stark phasensepariertes Semi-IPN zweier viskoelastischer Phasen vor.

In der WO 2012/061032 A1 werden Klebemassen offenbart, in denen ein reaktives Isocyanat-Prepolymer in einem Styrolblockcopolymer-Haftkleber dispergiert wurde, wobei dieses Prepolymer nach der Vernetzung mittels Luftfeuchte ein Semi-IPN innerhalb der Haftklebemassephase bildet. Dabei beträgt der Anteil des Reaktivharzes zwischen etwa 40 bis 70 Gew.-% der Haftklebemasse. Zwar wird auch auf die Möglichkeit der Bildung von vollständigen IPNs, Blends oder einer verstärkenden Phase hingewiesen (Anspruch1), doch belegen die Beispiele nur die Bildung von Semi-IPNs ([0038]). Diese Haftklebemassen haben den Nachteil, dass sie von Feuchtigkeit abgeschlossen gelagert werden müssen. Andere Reaktivharze werden zwar auch genannt, doch wird keine Lehre bezüglich weiterer günstiger Kombinationen offenbart.

In EP 1 658 319 B1 wird eine Formmasse, enthaltend ein Gemisch interpenetrierender Polymere mit einer ersten Phase eines vernetzten Isobutenpolymers und einer zweiten Phase eines versteifenden Polymers, das (Meth)acryl- und/oder Vinylaromateneinheiten umfasst, wobei die erste Phase das Reaktionsprodukt eines Isobutenpolymers mit durchschnittlich wenigstens 1,4-funktionellen Gruppen im Molekül und eines Vernetzungsmittels mit durchschnittlich wenigstens zwei funktionellen Gruppen im Molekül, die komplementär funktionell zu den funktionellen Gruppen des Isobutenpolymers sind, umfasst. Das IPN kann dabei simultan oder sequentiell - mit der vernetzten Isobutenphase als vorgelegtem Netzwerk - hergestellt werden. Es werden in den Beispielen keine haftklebrigen Formmassen offenbart.

Um die Verträglichkeit der ersten Phase mit der zweiten Phase zu verbessern, wird die die Mitverwendung von polymeren Kompatibilisierungsmitteln vorgeschlagen, zum Beispiel Polyethylenglykol. Die polymeren Kompatibilisierungsmittel sind vorzugsweise vernetzt. Das polymere Kompatibilisierungsmittel kann auf diese Weise ein die erste Phase penetrierendes Netzwerk bilden. Nachteilig an dieser Art der Kompatibilisierung ist die hohe Komplexität des nun ternären Systems, was die Steuerung der Eigenschaften erschwert.

In EP 2 160 443 B1 wird ein semi-interpenetrierendes Netzwerk mit einer ersten Phase eines linearen unvernetzten Isobutenpolymers und einer zweiten Phase eines vernetzten Polymers offenbart, wobei das vernetzte Polymer durch vernetzende Aufbaureaktion in Gegenwart des Isobutenpolymers erhalten ist. In der bevorzugten und mit Beispielen belegten Ausführung wird das vernetzte Polymer durch radikalische Polymerisation ethylenisch ungesättigter Monomere, insbesondere von Styrol und Methacrylaten, erhalten.

Die erhaltenen semi-interpenetrierenden Netzwerke mit einem Gewichtsverhältnis von PIB/Monomer-Phase von 70/30 bis zu 50/50 zeigen überwiegend zwei mechanische Relaxationen bei -50 °C und oberhalb Raumtemperatur, die für PIB und für das jeweilige zweite Polymer charakteristisch sind. Dies ist ein Hinweis auf das Vorliegen diskreter Polymerphasen. Die Phasenseparation ist überwiegend sehr stark, so dass aufgrund der Lichtstreuung weiße Materialien erhalten werden.

Vorzugsweise werden gemäß dieser Schrift Monomere und Monomerengemische verwendet, die ein Polymer beziehungsweise Copolymer mit einem Löslichkeitsparameter ergeben, der sich von dem des Isobutenpolymers um weniger als 1 MPa^{1/2}, vorzugsweise weniger als 0,7 MPa^{1/2}, insbesondere weniger als 0,5 MPa^{1/2} unterscheidet. Bei einer geringen Differenz zwischen den Löslichkeitsparametern des Isobutenpolymers und des vernetzten Polymers ist die gegenseitige Verträglichkeit der Polymere hoch und der extrahierbare Anteil des Netzwerks gering. Unter diesem Gesichtspunkt sind Styrol (Löslichkeitsparameterdifferenz Polyisobuten - Polystyrol = 0,31 MPa^{1/2}) und Cyclohexylmethacrylat (Löslichkeitsparameterdifferenz Polycyclohexylmethacrylat - Polystyrol = 0,20 MPa^{1/2}) besonders bevorzugt.

Die Art der Aufbaureaktion wird als nicht kritisch angesehen. Es kann sich zum Beispiel um eine Polymerisation ethylenisch ungesättigter Monomere, die radikalisch, anionisch oder kationisch katalysiert sein kann, eine Polyaddition oder eine Polykondensation handeln. Die radikalische Polymerisation wird jedoch bevorzugt.

Der Aufbau und die chemische Beschaffenheit des vernetzten Polymers werden ebenfalls als nicht kritisch bewertet, solange es aus Vorläufern hergestellt werden kann, die mit dem Isobutenpolymer zumindest teilweise mischbar sind. Eine technische Lösung für den Fall, dass keine hinreichende Mischbarkeit vorliegt, wird nicht offenbart.

Bei der Verwendung der Formulierungen als Klebstoff wird in der EP 2 160 443 B1 offenbart, dass eine gewisse Phasenseparation vor der Aufbaureaktion eintritt, so dass Isobutenpolymer an den äußeren Oberflächen austritt. Wiewohl eine bessere Benetzung dadurch erreicht wird, schwächt diese vom aufbauenden Konstituenten durchdrungene Grenzschicht später nicht mehr die Klebleistung (weak bondary layer). Für Klebebänder sind solche zur Phasenseparation neigenden Kompositionen daher nicht geeignet.

Ein anderer Weg der Herstellung mehrphasiger Morphologien ist auch die In-Situ-Erzeugung von zum Beispiel nanopartikulären Füllstoffen innerhalb einer Polymerphase oder während der Polymerisation. Dabei können die Füllstoffpartikel organischer, insbesondere polymerer, anorganischer oder hybrider Natur (zum Beispiel anorganischorganische Hybridmaterialien aus einem Sol-Gel-Prozess) sein. Auch in situ erzeugte komplexe mehrphasige Polymer-Polymer-Morphologien sind bekannt, zum Beispiel das High-Impact-Polystyrol (HIPS), bei dem die ineinander verschachtelten Kautschukdomänen durch freie radikalische Polymerisation von Styrol-Polybutadien-Lösungen unter permanentem Rühren erhalten werden. In der Regel liegt dabei das Material mit dem volumenbezogen kleineren Anteil als disperse Phase innerhalb des Materials mit dem größeren Anteil vor.

Ein gängiges Verfahren zur Erzeugung zweiphasiger Morphologien zum Beispiel in Epoxidharzklebstoffen ist der Zusatz eines endgruppenmodifizierten, epoxidreaktiven Polybutadien-Co-Acrylnitril-Copolymers zum ungehärteten Epoxidharz. Dabei muss das thermoplastische Polymer im ungehärteten Epoxidharz löslich werden, im Verlauf der Härtungsreaktion jedoch mit dem Epoxidharz-Polymer unverträglich sein, so dass es während der Härtung zur Phasenseparation kommt. Mit Erreichen des Gelpunktes wird der Phasenseparationsprozess gestoppt, so dass das thermoplastische beziehungsweise elastomere Polymer in Form von mikroskopischen sphärischen Domänen in der Epoxidharzmatrix vorliegt.

Im Bereich der Haftkleber sind mikrophasenseparierte Systeme ebenfalls bekannt. Beispielsweise gehören Haftklebstoffe auf der Basis von Styrolblockcopolymeren dazu, bei denen sich Domänen aus Polystyrol nach der Erstarrung aus einer Schmelze oder dem Abdunsten von Lösemittel bilden, die durch ihre Glasumwandlungstemperatur oberhalb der Raumtemperatur der Haftklebemasse eine erhöhte Kohäsion verleihen. Dies wird oft auch "physikalische Vernetzung" genannt (siehe DE 103 61 540 A1).

Bekannt ist auch, in solche Haftklebemassen Reaktivharze einzumischen, die nach der Applikation der Haftklebemasse zur Vernetzung gebracht werden.

In DE 10 2004 031 188 A1 und DE 103 61 540 A1 werden Klebemassen offenbart, die zumindest aus a) einem säure- oder säureanhydridmodifizierten Vinylaromatenblockcopolymer und b) einer epoxidhaltigen Verbindung bestehen. Durch die chemische Vernetzung der Harze mit den Elastomeren werden sehr große Festigkeiten innerhalb des Klebefilms erreicht. Aufgrund der Vernetzung handelt sich also nicht um IPNs. Um die Adhäsion zu erhöhen, ist auch der Zusatz von mit dem Elastomerblock der Blockcopolymere verträglichen Klebharzen möglich. Die säurebeziehungsweise säureanhydridmodifizierten Elastomere und Epoxidharze werden in einem Mengenverhältnis eingesetzt, so dass der molare Anteil an Epoxidgruppen und Anhydridgruppen gerade äquivalent ist. Bei der Verwendung der gängigen nur gering modifizierten Elastomere und dem Einsatz niedermolekularer Epoxidharze mit einem niedrigen Epoxidäquivalent ergeben sich dabei nur sehr geringe Mengen - von unter 10 Gew.-% bezogen auf das modifizierte Styrolblockcopolymer - an Epoxidharz, die eingesetzt werden. Im Wesentlichen wirkt so das Epoxidharz als Vernetzungsagens für die modifizierten Elastomere und bildet allenfalls in geringem Maße eine eigene zweite Phase aus.

US 6,294,270 B, US 6,423,367 B und US 6,489,042 B beschreiben vernetzbare Mischungen aus epoxidierten Vinylaromatenblockcopolymeren und Epoxidharzen unter anderem auch als Klebmasse für die Verklebung zweier elektronischer Bauteile. Aufgrund der Vernetzung handelt es sich also nicht um IPNs. Hauptsächlich ist eine Vernetzung durch Bestrahlung mit UV-Licht beschrieben. Für diesen Zweck hat sich hier ein sehr hoher Anteil von über 90 Gew.-% des epoxidierten Vinylaromatenblockcopolymers als beste Lösung erwiesen. Im Wesentlichen wirkt auch hier das Epoxidharz als Vernetzungsagens für die modifizierten Elastomere und bildet allenfalls in geringem Maße eine eigene zweite Phase aus.

Die Lehre dieser (fünf) vorgenannten Schriften lässt den Fachmann ableiten, dass es sich jeweils um ein homogenes Blend von Reaktivharz und modifiziertem Blockcopolymer handeln muss, welches sich durch eine gute Verträglichkeit dieser zumindest zwei Komponenten auszeichnet. Durch die vorteilhafte geringe Reaktivharzmenge wird die Gefahr einer Unverträglichkeit und damit Phasenbildung auch nach der Vernetzung des Reaktivharzes gemindert.

In DE 10 2004 031 190 A1 wird eine Klebemasse, die zumindest aus a) einem epoxidmodifizierten Vinylaromatenblockcopolymer, b) einem Epoxidharz und c) einem Härter, der bei hohen Temperaturen eine Vernetzung mit den Epoxidgruppen vollführt, wobei das Verhältnis von a und b zwischen 40 : 60 und 80 : 20 liegt, offenbart. Durch die chemische Vernetzung des Harzes mit dem Elastomer werden sehr große Festigkeiten innerhalb des Klebefilms erreicht. Aufgrund der Vernetzung handelt es sich also nicht um ein IPN. Um die Adhäsion zu erhöhen, ist auch der Zusatz von mit dem Elastomerblock der Blockcopolymere verträglichen Klebharzen möglich. Werden Elastomere eingesetzt, die nicht chemisch vernetzbar sind, sind, wie im Vergleichsbeispiel gezeigt, die Klebkräfte deutlich niedriger als bei solchen mit Vernetzungsmöglichkeit.

Zu mehrphasigen Haftklebemassen zählen insbesondere auch solche Haftklebemassen, bei denen Füllstoffe kovalent an Komponenten der Haftklebemasse, insbesondere das Basispolymer gebunden sind (siehe WO 2006/120136 A1). Vorteilhaft sind die Füllstoffe nanoskalig. Nachteilig an dieser Lösung ist die Schwierigkeit, die nanoskaligen Füllstoffe homogen und ohne die Ausbildung von Agglomeraten in der Matrix zu verteilen.

Es besteht somit ein anhaltender Bedarf an Lösungen, Haftklebemassen mit spezifisch eingestellten Adhäsions- und Kohäsionseigenschaften bereitzustellen.

Aufgabe der vorliegenden Erfindung ist es daher, eine Haftklebemasse zur Verfügung zu stellen, die ein IPN enthält und damit die Vorteile dieser Technologie nutzen kann, aber Nachteile des Stands der Technik, wie insbesondere mangelnde Transparenz, vermeidet. Weiterhin besteht Bedarf an einem Verfahren, solche Haftklebemassen zuverlässig herzustellen und Hürden, wie zum Beispiel die mangelnde Verträglichkeit der Polymerkonstituenten und damit ein geringes Portfolio bei der Auswahl der Polymerkonstituenten, zu überwinden.

Gelöst wird diese Aufgabe durch eine Haftklebemasse, wie sie im Hauptanspruch näher gekennzeichnet ist. In den Unteransprüchen sind vorteilhafte Ausführungsformen der Erfindung beschrieben. Des Weiteren sind Verwendungen der erfindungsgemäßen Haftklebemasse sowie Verfahren zur Herstellung vom erfinderischen Gedanken umfasst.

Demgemäß betrifft die Erfindung eine Haftklebemasse, umfassend mindestens zwei jeweils eine Phase bildende Bestandteile, aus denen durch insbesondere vernetzende Aufbaureaktion ein IPN mit mindestens zwei Phasen entsteht, wobei die erste Phase (Elastomerphase) zumindest eine Erweichungstemperatur nach DSC von kleiner 23 °C und die zweite Phase nach der Aufbaureaktion eine Erweichungstemperatur nach DSC von größer 23 °C aufweist und wobei die zweite Phase nach der Aufbaureaktion die Morphologie eines verbundenen Nanopartikelnetzwerks aufweist.

Unter dem Erweichungspunkt versteht man die Temperatur (beziehungsweise den Temperaturbereich), bei dem amorphe oder teilkristalline Polymere vom glasigen beziehungsweise teilkristallinen, hartelastischen in einen weichen Zustand übergehen.

Die Erweichungstemperatur von Homopolymeren, Copolymeren, Hart- und Weichblöcken und ungehärteten Reaktivharzen wird kalorimetrisch über die Differential Scanning Calorimetry (DSC) nach DIN 53765:1994-03 bestimmt. Aufheizkurven und Kühlkurven laufen mit einer Rate von 10 K/min. Die Muster werden in Al-Tiegeln mit gelochtem Deckel und Stickstoffatmosphäre vermessen. Es wird die zweite Aufheizkurve ausgewertet. Bei amorphen Stoffen werden die auftretenden Glasübergangstemperaturen als Erweichungstemperatur definiert, bei (semi)kristallinen Stoffen die Schmelztemperaturen. Ein Glasübergang ist als Stufe im Thermogramm erkennbar. Die Glasübergangstemperatur wird als Mittelpunkt dieser Stufe ausgewertet. Eine Schmelztemperatur ist als Peak im Thermogramm erkennbar. Als Schmelztemperatur wird diejenige Temperatur notiert, bei der die höchste Wärmetönung auftritt.

Die erfindungsgemäße Haftklebemasse umfasst also ein IPN, welches aus einer nicht oder wenig vernetzten Phase (Elastomerphase) und einer stark vernetzten Phase (Hartphase) besteht, wobei die Hartphase die Morphologie eines verbundenen Nanopartikelnetzwerks ausbildet.

Bevorzugt ist das IPN ein Semi-IPN, bei der die erste Phase, die Elastomerphase, nicht vernetzt, insbesondere nicht kovalent vernetzt vorliegt.

Verschlaufungen von Molekülketten (Entanglements) werden mit einer Ausnahme im Sinne der Erfindung nicht als Vernetzung angesehen, und zwar wird im Sinne der Erfindung definiert, dass eine Vernetzung über multiple Kettenverschlaufungen, daraus resultierend, dass das Gewichtsmittel M_{w} der ersten Phase (Elastomerphase) zumindest dem 5fachen, vorzugsweise dem 25fachen Entanglementmolekulargewicht entspricht, als eine Variante einer physikalischen Vernetzung angesehen wird.

Obwohl auch Kautschuke chemisch vernetzt werden können, so sind sie, sofern ihre Molmassen hoch genug liegen (was bei vielen natürlichen und synthetischen Systemen der Fall ist), auch ohne zusätzliche Vernetzung einsetzbar. Die gewünschten elastischen Eigenschaften resultieren in langkettigen Kautschuken aus den Verschlaufungen, beziehungsweise den Verschlaufungsmolmassen, die polymercharakteristisch (siehe zum Konzept und für eine Reihe von Polymeren L. J. Fetters et al., Macromolecules, 1994, 27, Seiten 4639 bis 4647) sind.

Bevorzugt ist die Elastomerphase physikalisch (zum Beispiel durch Domänenbildung bei Blockcopolymeren) oder koordinativ.
Beispiele für koordinative Bindungen sind Ligand-Zentralatom-Bindungen in Komplexen, also die Bildung einer koordinativen Bindung mit Metallatomen, die elementar, in Form von Metallsalzen und/oder in Form von Metallkomplexen vorliegen können, sowie alle weiteren Donor-Akzeptor-Bindungen [siehe hierzu beispielsweise D. Philp, J. F. Stoddard, Angew. Chem., 1996, 108, 1242; M. Rehahn, Acta Polym., 1998, 49, 201; B. G. G. Lohmeijer, U. S. Schubert, J. Polym. Sci. A Polym. Chem., 2003, 41, 1413 und jeweils darin zitierte Literatur].
Ein Beispiel ist die Koordination von Säuregruppen an Metallchelaten.

Erhalten wird eine solche Haftklebemasse durch ein Verfahren zur Herstellung eines verbundenen Nanopartikelnetzwerks, gekennzeichnet durch folgende Schritte:
1. Herstellung einer bevorzugt homogenen Mischung aus zumindest einem Elastomer, zumindest einer Reaktivkomponente (Reaktivharz/Monomer) und optional einem Klebharz, bei der der Massenanteil der Reaktivkomponente kleiner oder gleich (nicht größer) ist als die Summe des Elastomers und des optionalen Klebharzes
2. Starten der Aufbaureaktion des Reaktivharzes/Monomers, wobei aus dem Reaktivharz/Monomer disperse Nanopartikeln aufgebaut werden, die sich zu einem Netzwerk aus Nanopartikeln innerhalb der Elastomerphase verbinden.

Die Aufbaureaktion kann eine Vernetzungsreaktion, eine Polymerisation oder eine ein-, zwei- oder dreidimensionale Kettenwachstumsreaktion sein.

Die Schritte können auch simultan zueinander erfolgen, insbesondere der Aufbau der Nanopartikel sowie die gleichzeitige Verbindung derselben während des Aufbaus.
Die Schritte 1 und 2 können simultan verlaufen, wenn zum Beispiel mit dem Zusammenmischen der Komponenten bereits die Reaktion gestartet wird.

Überraschend wurde gefunden, dass bei Vorliegen eines solchen verbundenen Netzwerks sowohl die verstärkenden Eigenschaften einer weit verzweigten oder sogar durchgehenden Hartphase (zweite Phase) zum Tragen kommen als auch die hohe Transparenz der Haftklebemasse erhalten bleibt.

Als überraschendes Moment ist festzuhalten, dass sich für den Fachmann bei der Herstellung von Haftklebemassen auf der Basis von IPNs folgende Möglichkeiten ergeben:
1. Beim Aufbau des IPNs findet keine Phasenseparation statt, was nur eintritt, wenn die Konstituenten unter den gegebenen Reaktionsbedingungen sehr gut miteinander verträglich sind. Dieser Fall ist, wie bereits oben erläutert, sehr selten. Werden Klebemassen auf der Basis solcher IPNs angestrebt, so ergeben sich nur eine sehr geringe Auswahl möglicher Kombinationen von Konstituenten und somit nur geringe Variationsmöglichkeiten in der Formulierung solcher Klebemassen.
2. Die Auswahl der Konstituenten und Reaktionsbedingungen ist so erfolgt, dass sich disperse, oft sphärische Domänen der Hartphase innerhalb der Elastomerphase bilden. Diese Phasen können eine Größe aufweisen, dass sie unter den gegebenen Brechungsindexunterschieden das Licht streuen oder nicht streuen. Damit können transparente oder nicht transparente Klebemassen erreicht werden. Allerdings ist diese Phasenausbildung für den Fachmann weniger bevorzugt, da die verstärkende Wirkung der Hartphase im wesentlichen mit der von Füllstoffen, zum Beispiel von nanopartikulären Füllstoffen, verglichen werden kann und gegenüber diesen keinen Vorteil aufweist.
3. Insofern würde der Fachmann, sofern ein IPN wie unter 1. nicht erreichbar ist, zumindest eine kokontinuierliche Ausbildung der Hartphase mit der Elastomerphase anstreben, damit die Hartphase eine ausgeprägte Verstärkungswirkung innerhalb des Elastomers entfalten kann. Zur Ausbildung einer solchen Morphologie ist aber ein ausreichend großer Volumenanteil der Hartphase erforderlich, den der Fachmann zunächst grob mit 50 Vol.-% abschätzen würde. Bei dieser großen Menge an Hartphase ist selbst bei in geringen Mengen verträglichen Reaktivharzen/Monomeren mit verstärkten Unverträglichkeiten zu rechnen, so dass die kokontinuierliche Morphologie eher grob ausgebildet wird (das heißt auf Längenskalen der ineinander verschachtelten Zellen im Bereich oberhalb 100 nm), so dass intransparente Klebemassen erwartet werden, sofern der Brechungsindex der Konstituenten nicht sehr ähnlich ist.
   In EP 2 160 443 B1 wird die Anpassung des Brechungsindexes als probate Maßnahme zur Herstellung von Transparenz in solchen Systemen beschrieben. Kann diese Maßnahme nicht verwirklicht werden, würde der Fachmann anstreben, die kokontinuierliche Struktur so fein wie möglich auszubilden.

Mit der überraschend gefundenen Struktur des verbundenen Nanopartikelnetzwerks lassen sich diese Hürden in der Entwicklung von auch transparenten Haftklebemassen, die ein IPN enthalten, überwinden.

Durch den Aufbau aus Nanopartikeln wird die Ausbildung der grobskaligen kokontinuierlichen Struktur vermieden, da die kokontinuierliche Struktur aus nanoskaligen Strukturelementen aufgebaut wird. Zudem kann eine derartige kokontinuierliche Struktur bereits mit weniger Volumenanteil der Hartphase erhalten werden, als im Falle einer klassischen Phasenseparation. Das verbundene Nanopartikelnetzwerk liegt idealerweise in Form einer Perlenkettenstruktur (wie sie zum Beispiel von Aerogelen bekannt ist) vor, kann aber auch andersförmig ausgeprägt sein.

Als Haftklebemassen werden Klebemassen bezeichnet, die bereits unter relativ schwachem Andruck eine dauerhafte Verbindung mit dem Haftgrund erlauben und nach Gebrauch im Wesentlichen rückstandsfrei vom Haftgrund wieder abgelöst werden können. Haftklebemassen wirken bei Raumtemperatur permanent haftklebrig, weisen also eine hinreichend geringe Viskosität und eine hohe Anfassklebrigkeit auf, so dass sie die Oberfläche des jeweiligen Klebegrunds bereits bei geringem Andruck benetzen. Die Verklebbarkeit entsprechender Klebemassen beruht auf ihren adhäsiven Eigenschaften und die Wiederablösbarkeit auf ihren kohäsiven Eigenschaften. Als Basis für Haftklebemassen kommen verschiedene Materialien in Frage.

Als Haftklebemasse können alle dem Fachmann bekannten Haftklebemassen eingesetzt werden, also zum Beispiel solche auf der Basis von Acrylaten und/oder Methacrylaten, Polyurethanen, Naturkautschuken, Synthesekautschuken, Styrolblockcopolymermassen mit einem Elastomerblock aus ungesättigten oder hydrierten Polydienblöcken (Polybutadien, Polyisopren, Copolymeren aus beiden sowie weitere, dem Fachmann geläufige Elastomerblöcke), Polyolefinen, Fluorpolymeren und/oder Silikonen. Darunter fallen auch weitere Massen, die haftklebende Eigenschaften entsprechend dem "Handbook of Pressure Sensitive Adhesive Technology" von Donatas Satas (Satas & Associates, Warwick 1999) besitzen, insbesondere solche, die das Dahlquist-Kriterium erfüllen.

Wird im Rahmen dieser Schrift von Haftklebemassen auf Acrylatbasis gesprochen, so sind hiervon auch ohne explizite Erwähnung Haftklebemassen auf Basis von Methacrylaten und auf Basis von Copolymeren bestehend aus Acrylaten und Methacrylaten gemeint, sofern nicht ausdrücklich anders beschreiben. Ebenfalls im Sinne der Erfindung sind Kombinationen und Blends mehrerer Basispolymere sowie mit Klebharzen, Füllstoffen, Alterungsschutzmitteln und Vernetzern additivierte Klebemassen, wobei die Aufzählung der Additive nur beispielhaft und nicht einschränkend zu verstehen ist.

Als Elastomerphase können prinzipiell alle im Bereich der Haftklebemassen üblichen Elastomere verwendet werden, wie sie zum Beispiel in dem "Handbook of Pressure Sensitive Adhesive Technology" von Donatas Satas (Satas & Associates, Warwick 1999), beschrieben sind.

Dies sind zum Beispiel Elastomere auf der Basis von Acrylaten und/oder Methacrylaten, Polyurethanen, Naturkautschuken, Synthesekautschuken wie Butyl-, (Iso)Butyl-, Nitril- oder Butadienkautschuke, Styrolblockcopolymeren mit einem Elastomerblock aus ungesättigten oder teilweise oder vollständig hydrierten Polydienblöcken (Polybutadien, Polyisopren, Poly(iso)butylen, Copolymeren aus diesen sowie weitere, dem Fachmann geläufige Elastomerblöcke), Polyolefinen, Fluorpolymeren und/oder Silikonen.
Kommt Kautschuk oder Synthesekautschuk oder daraus erzeugte Verschnitte als Basismaterial für die Haftklebemasse zum Einsatz, dann kann der Naturkautschuk grundsätzlich aus allen erhältlichen Qualitäten wie zum Beispiel Crepe-, RSS-, ADS-, TSR- oder CV-Typen, je nach benötigtem Reinheits- und Viskositätsniveau, und der Synthesekautschuk oder die Synthesekautschuke aus der Gruppe der statistisch copolymerisierten Styrol-Butadien-Kautschuke (SBR), der Butadien-Kautschuke (BR), der synthetischen Polyisoprene (IR), der Butyl-Kautschuke (IIR), der halogenierten Butyl-Kautschuke (XIIR), der Acrylat-Kautschuke (ACM), der Ethylenvinylacetat-Copolymere (EVA) oder der Polyurethane und/oder deren Verschnitten gewählt werden.

Diese Elastomere haben gemäß einer bevorzugten Ausführungsform der Erfindung eine Molmasse, die größer ist als ihre 5fache, vorzugsweise 25fache Entanglementmolmasse. "Auf der Basis von" oder "auf der Grundlage von" bedeutet vorliegend, dass die Eigenschaften der Polymermischung zumindest stark von den grundlegenden Eigenschaften dieses Polymers (dem so genannten "Basispolymer") bestimmt werden, wobei selbstverständlich nicht ausgeschlossen ist, dass diese durch Verwendung von modifizierenden Hilfs- oder Zusatzstoffen oder von weiteren Polymeren in der Zusammensetzung zusätzlich beeinflusst werden. Insbesondere kann dies bedeuten, dass der Anteil des Basispolymers an der Gesamtmasse der elastomeren Phase mehr als 50 Gew.-% beträgt.

Das Polymer kann von linearer, verzweigter, sternförmiger oder gepfropfter Struktur sein, um nur einige Beispiele zu geben, und als Homopolymer, als statistisches Copolymer, als alternierendes oder als Blockcopolymere aufgebaut sein. Die Bezeichnung "statistisches Copolymer" beinhaltet im Sinne dieser Erfindung nicht nur solche Copolymere, in denen die bei der Polymerisation eingesetzten Comonomere rein statistisch eingebaut sind, sondern auch solche, bei denen Gradienten in der Comonomerzusammensetzung und/oder lokale Anreicherungen einzelner Comonomersorten in den Polymerketten vorkommen. Einzelne Polymerblöcke können als Copolymerblock (statistisch oder alternierend) aufgebaut sein.

Bevorzugt werden Elastomerphasen auf der Basis von Blockcopolymeren, insbesondere Vinylaromaten-Blockcopolymeren eingesetzt.
Durch den Vinylaromatenblock wird zum einen eine physikalische Vernetzung durch die Domänenbildung der Haftklebemasse herbeigeführt, zum anderen können die Vinylaromatenblöcke als Kompatibilisatoren für die Reaktivkomponente wirken, und so die Herstellung einer homogenen Mischung erleichtern. Aber auch Blockcopolymere mit Acrylat-Weichblock sind besonders geeignet.

Die Hartphase des erfindungsgemäßen interpenetrierenden Netzwerks wird von einem insbesondere vernetzten Polymer gebildet, dessen Erweichungspunkt größer als 23 °C ist. Das insbesondere vernetzte Polymer wird bevorzugt durch vernetzende Aufbaureaktion in Gegenwart der Elastomerphase (sequentielles-IPN) erhalten. Unter einer vernetzenden Aufbaureaktion wird eine Umsetzung verstanden, bei der parallel zum Aufbau eines Makromoleküls aus Reaktivkomponenten (monomere und/oder oligomere Bestandteilen) Verzweigungen und/oder Vernetzungen in die wachsenden Polymerketten eingebaut werden.

Als Reaktivkomponente können im Prinzip alle, dem Fachmann im Bereich der Haftklebemassen oder Reaktivklebstoffe bekannten, in einer Aufbaureaktion vernetzenden Makromoleküle bildenden reaktiven Konstituenten verwendet werden, wie sie zum Beispiel in Gerd Habenicht: Kleben -Grundlagen, Technologien, Anwendungen, 6. Auflage, Springer, 2009, beschrieben sind. Dies sind beispielhaft Konstituenten, die Epoxide, Polyester, Polyether, Polyurethane, Phenolharz-, Kresol oder Novolak basierte Polymere, Polysulfide oder Acrylpolymere (Acryl, Methacryl) bilden.

Der Aufbau und die chemische Beschaffenheit der Hartphase sind nicht kritisch, solange sie aus Vorläufern hergestellt werden kann, die mit der Elastomerphase zumindest teilweise mischbar sind und die Aufbaureaktion unter Bedingungen, insbesondere hinsichtlich der angewendeten Temperaturen, Art der verwendeten Katalysatoren und dergleichen, durchgeführt werden kann, die zu keiner wesentlichen Beeinträchtigung und/oder Zersetzung der Elastomerphase führen.

Das Massenverhältnis von Elastomerphase zu Hartphase kann von 85:15 bis zu 50:50 betragen. Bei einem Hartphasenanteil von mehr als 50 Gew.-% wird in der Regel keine Ausbildung der erfindungsgemäßen Struktur, also eine durch verbundene Partikel gebildete kokontinuierliche Struktur, mehr beobachtet, es ergibt sich in der Regel eine bekannte kokontinuierliche Struktur, also eine homogene, nicht durch verbundene Partikel gebildete kokontinuierliche Struktur, oder sogar eine Phasenumkehr, so dass die Hartphase als Matrix vorliegt, in der die Elastomerphase dispergiert ist. Erfindungsgemäß bevorzugt ist daher ein Hartphasenanteil von kleiner/gleich 50 Gew.-%, weil ansonsten die Haftklebemasse zu weich wird, das heißt, diese ist in ihrer Handhabbarkeit in ihrem nicht ausgehärteten Zustand nicht mehr vorteilhaft gegenüber Flüssigklebern.
Ein Hartphasenanteil von größer/gleich 15 Gew.-% wird bevorzugt, weil anderenfalls die Hartphase häufig eine disperse Morphologie einnimmt.

Bevorzugt ist ein Massenverhältnis von Elastomerphase zu Hartphase von 80:20 bis zu 60:40, da in diesem Bereich Haftklebemassen erreicht werden können, die eine für die technische Anwendung ausreichende Kohäsionserhöhung durch die mittels der Aufbaureaktion erhaltenen erfindungsgemäßen Struktur aufweisen, ohne jedoch spröde zu werden.

Bevorzugt ist ein Massenverhältnis von Elastomerphase zu Hartphase von 85:15 bis zu 80:20, da in diesem Bereich Haftklebemassen erreicht werden können, die im nicht ausgehärteten Zustand, also bevor die Aufbaureaktion stattgefunden hat, einen genügende Lagerstabilität auf der Rolle (keine wesentliches Ausfließen an den Kanten) aufweisen.

Bevorzugt ist ein weiteres Massenverhältnis von Elastomerphase zu Hartphase von 85:15 bis zu 65:35, insbesondere von 80:20 bis zu 70:30, da in diesem Bereich Haftklebemassen erreicht werden können, die einen guten Kompromiss zwischen Fließfähigkeit im Zustand vor der Aufbaureaktion und Kohäsion in der erfindungsgemäßen Struktur aufweisen.

Im Folgenden werden bevorzugte Ausführungen der Erfindung dargestellt.
Der Aufbau der Hartphase erfolgt bevorzugt über (als langsam zu bezeichnende) Reaktionsmechanismen, bei denen die Lebenszeit der reaktiven Spezies > 1 s, besonders bevorzugt > 1 min ist. Dies gilt insbesondere für kationische und kontrolliert radikalische Polymerisationen, bei denen die Anzahl verknüpfter Monomere in dem gebildeten Polymer zeitabhängig ist. Dies ist bei freien radikalischen Polymerisationen nicht der Fall.
Die Aufbaureaktion erfolgt bevorzugt kationisch oder mittels eines kontrollierten radikalischen Mechanismus (zum Beispiel RAFT, ATRP, NMRP). Bei diesen Reaktionstypen kann die Zahl der Reaktionskeime und damit Anzahl und Größe der Partikel über die Initiator- beziehungsweise Reglermenge festgelegt werden, da nur ausgehend von diesen Keimen Partikel wachsen. Bei der freien radikalischen Polymerisation ist die Anzahl der Partikel unter anderem von der Zahl der Kettenübertragungsreaktionen abhängig und damit kaum zu steuern.

Kommen als Elastomere Blockcopolymere zum Einsatz, dann enthalten diese zumindest eine Blocksorte mit einer Erweichungstemperatur von größer 40 °C wie zum Beispiel Vinylaromaten (auch teil- oder vollhydrierte Varianten), Methylmethacrylat, Cyclohexylmethacrylat, Isobornylmethacrylat und Isobornylacrylat.
Weiter vorzugsweise enthält das Blockcopolymer eine Blocksorte mit einer Erweichungstemperatur von kleiner -20 °C.
Beispiele für Polymerblöcke mit niedrigen Erweichungstemperaturen ("Weichblöcke") sind Polyether wie zum Beispiel Polyethylenglykol, Polypropylenglykol oder Polytetrahydrofuran, Polydiene wie zum Beispiel Polybutadien oder Polyisopren, (teil)hydrierte Polydiene wie zum Beispiel Polyethylenbutylen, Polyethylenpropylen oder Polybutylenbutadien, Polybutylen, Polyisobutylen, Polyalkylvinylether, Polymerblöcke α,β-ungesättigter Ester wie insbesondere Acrylat-Copolymere.

Der Weichblock ist dabei in einer Auslegung unpolar aufgebaut und enthält dann bevorzugt Butylen oder Isobutylen oder hydrierte Polydiene als Homopolymerblock oder Copolymerblock, letztere vorzugsweise mit sich selbst oder miteinander oder mit weiteren besonders bevorzugt unpolaren Comonomeren copolymerisiert. Als unpolare Comonomere sind beispielsweise (teil-) hydriertes Polybutadien, (teil-)hydriertes Polyisopren und/oder Polyolefine geeignet.

Die erfindungsgemäße Haftklebemasse enthält gemäß einer bevorzugten Ausführungsform zumindest eine Sorte eines Reaktivharzes auf Basis eines cyclischen Ethers für die strahlenchemische und gegebenenfalls thermische Vernetzung mit einer Erweichungstemperatur von kleiner 40 °C, bevorzugt von kleiner 20 °C.
Bei den Reaktivharzen auf Basis cyclischer Ether handelt es sich insbesondere um Epoxide, also Verbindungen, die zumindest eine Oxiran-Gruppe tragen, oder Oxetane. Sie können aromatischer oder insbesondere aliphatischer oder cycloaliphatischer Natur sein.
Einsetzbare Reaktivharze können monofunktionell, difunktionell, trifunktionell, tetrafunktionell oder höher funktionell bis zu polyfunktionell gestaltet sein, wobei sich die Funktionalität auf die cyclische Ethergruppe bezieht.

Beispiele, ohne sich einschränken zu wollen, sind 3,4-Epoxycyclohexylmethyl-3',4'-epoxycyclohexancarboxylat (EEC) und Derivate, Dicyclopendadiendioxid und Derivate, 3-Ethyl-3-oxetanmethanol und Derivate, Tetrahydrophthalsäurediglycidylester und Derivate, Hexahydrophthalsäurediglycidylester und Derivate, 1,2-Ethandiglycidylether und Derivate, 1,3-Propandiglycidylether und Derivate, 1,4-Butandioldiglycidylether und Derivate, höhere 1,n-Alkandiglycidylether und Derivate, Bis-[(3,4-epoxycyclohexyl)methyl]-adipat und Derivate, Vinylcyclohexyldioxid und Derivate, 1,4-Cyclohexandimethanol-bis-(3,4-epoxycyclohexancarboxylat) und Derivate, 4,5-Epoxytetrahydrophthalsäurediglycidylester und Derivate, Bis-[1-ethyl(3-oxetanyl)methyl)ether und Derivate, Pentaerythritoltetraglycidylether und Derivate, Bisphenol-A-Digylcidylether (DGEBA), hydriertes Bisphenol-A-Diglycidylether, Bisphenol-F-Diglycidylether, hydriertes Bisphenol-F-Diglycidylether, Epoxyphenol-Novolaks, hydrierte Epoxyphenol-Novolaks, Epoxycresol-Novolaks, hydrierte Epoxycresol-Novolaks, 2-(7-Oxabicyclo;Spiro[1,3-dioxane-5,3'-[7]oxabicyclo[4.1.0]-heptane], 1,4-Bis((2,3-epoxypropoxy)methyl)cyclohexane.

Reaktivharze können in ihrer monomeren oder auch dimeren, trimeren, usw. bis hin zu ihrer oligomeren Form eingesetzt werden.

Gemische von Reaktivharzen untereinander aber auch mit anderen coreaktiven Verbindungen wie Alkoholen (monofunktionell oder mehrfach funktionell) oder Vinylethern (monofunktionell oder mehrfach funktionell) sind ebenfalls möglich.

Die Klebmasseformulierung enthält zudem zumindest eine Sorte eines Photoinitiators für die kationische Härtung der Reaktivharze. Unter den Initiatoren für eine kationische UV-Härtung sind insbesondere Sulfonium, lodonium und Metallocen basierende Systeme einsetzbar.

Als Beispiele für Sulfonium basierende Kationen sei auf die Ausführungen in US 6,908,722 B1 (insbesondere Spalten 10 bis 21) verwiesen.

Als Beispiele für Anionen, die als Gegenionen für die oben genannten Kationen dienen, seien Tetrafluoroborat, Tetraphenylborat, Hexafluorophosphat, Perchlorat, Tetrachloroferrat, Hexafluoroarsenat, Hexafluoroantimonat, Pentafluorohydroxyantimonat, Hexachloroantimonat, Tetrakispentafluorophenylborat, Tetrakis-(pentafluoromethylphenyl)-borat, Bi-(trifluoromethylsulfonyl)-amide und Tris-(trifluoromethylsulfonyl)-methide genannt. Ferner sind insbesondere für lodoniumbasierende Initiatoren auch Chlorid, Bromid oder lodid als Anionen denkbar, wobei aber Initiatoren, die im Wesentlichen frei von Chlor und Brom sind, bevorzugt sind.

Konkreter zählen zu den einsetzbaren Systemen
- Sulfonium-Salze (siehe zum Beispiel US 4,231,951 A, US 4,256,828 A, US 4,058,401 A, US 4,138,255 A und US 2010/063221 A1) wie Triphenylsulfoniumhexafluoroarsenat, Triphenylsulfoniumhexafluoroborat, Triphenylsulfoniumtetrafluoroborat, Triphenylsulfoniumtetrakis-(pentafluorobenzyl)-borat, Methyldiphenylsulfoniumtetrafluoroborat, Methyldiphenylsulfoniumtetrakis-(pentafluorobenzyl)-borat, Dimethylphenylsulfoniumhexafluorophosphat, Triphenylsulfoniumhexafluorophosphat, Triphenylsulfoniumhexafluoroantimonat, Diphenylnaphthylsulfoniumhexafluoroarsenat, Tritolylsulfoniumhexafluorophosphat, Anisyldiphenylsulfoniumhexafluoroantimonat, 4-Butoxyphenyldiphenylsulfoniumtetrafluoroborat, 4-Butoxyphenyldiphenylsulfoniumtetrakis-(pentafluorobenzyl)-borat, 4-Chlorophenyldiphenylsulfoniumhexafluoroantimonat, Tris-(4-phenoxyphenyl)-sulfoniumhexafluorophosphat, Di-(4-ethoxyphenyl)-methylsulfoniumhexafluoroarsenat, 4-Acetylphenyldiphenylsulfoniumtetrafluoroborat, 4-Acetylphenyldiphenylsulfoniumtetrakis-(pentafluorobenzyl)-borat, Tris-(4-thiomethoxyphenyl)-sulfoniumhexafluorophosphat, Di-(methoxysulfonylphenyl)-methylsulfoniumhexafluoroantimonat, Di-(methoxynaphthyl)-methylsulfoniumtetrafluoroborat, Di-(methoxynaphthyl)-methylsulfoniumtetrakis-(pentafluorobenzyl)-borat, Di-(carbomethoxyphenyl)-methylsulfoniumhexafluorophosphat, (4-Octyloxyphenyl)-diphenylsulfoniumtetrakis-(3,5-bis-trifluoromethylphenyl)-borat, Tris-[4-(4-acetylphenyl)-thiophenyl]-sulfoniumtetrakis-(pentafluorophenyl)-borat, Tris-(dodecylphenyl)-sulfoniumtetrakis-(3,5-bis-trifluoromethylphenyl)-borat, 4-Acetamidphenyldiphenylsulfoniumtetrafluoroborat, 4-Acetamidphenyldiphenylsulfoniumtetrakis-(pentafluorobenzyl)-borat, Dimethylnaphthylsulfoniumhexafluorophosphat, Trifluoromethyldiphenylsulfoniumtetrafluoroborat, Trifluoromethyldiphenylsulfoniumtetrakis-(pentafluorobenzyl)-borat, Phenylmethylbenzylsulfoniumhexafluorophosphat, 5-Methylthianthreniumhexafluorophosphat, 10-Phenyl-9,9-dimethylthioxantheniumhexafluorophosphat, 10-Phenyl-9-oxothioxantheniumtetrafluoroborat, 10-Phenyl-9-oxothioxantheniumtetrakis-(pentafluorobenzyl)-borat, 5-Methyl-10-oxothianthreniumtetrafluoroborat, 5-Methyl-10-oxothianthreniumtetrakis-(pentafluorobenzyl)-borat und 5-Methyl-10,10-dioxothianthreniumhexafluorophosphat,
- lodonium-Salze (siehe zum Beispiel US 3,729,313 A, US 3,741,769 A, US 4,250,053 A, US 4,394,403 A und US 2010/063221 A1) wie Diphenyliodoniumtetrafluoroborat, Di-(4-methylphenyl)-iodoniumtetrafluoroborat, Phenyl-4-methylphenyliodoniumtetrafluoroborat, Di-(4-chlorphenyl)-iodoniumhexafluorophosphat, Dinaphthyliodoniumtetrafluoroborat, Di-(4-trifluormethylphenyl)-iodoniumtetrafluoroborat, Diphenyliodoniumhexafluorophosphat, Di-(4-methylphenyl)-iodoniumhexafluorophosphat, Diphenyliodoniumhexafluoroarsenat, Di-(4-phenoxyphenyl)-iodoniumtetrafluoroborat, Phenyl-2-thienyliodoniumhexafluorophosphat, 3,5-Dimethylpyrazolyl-4-phenyliodoniumhexafluorophosphat, Diphenyliodoniumhexafluoroantimonat, 2,2'-Diphenyliodoniumtetrafluoroborat, Di-(2,4-dichlorphenyl)-iodoniumhexafluorophosphat, Di-(4-bromphenyl)-iodoniumhexafluorophosphat, Di-(4-methoxyphenyl)-iodoniumhexafluorophosphat, Di-(3-carboxyphenyl)-iodoniumhexafluorophosphat, Di-(3-methoxycarbonylphenyl)-iodoniumhexafluorophosphat, Di-(3-methoxysulfonylphenyl)-iodoniumhexafluorophosphat, Di-(4-acetamidophenyl)-iodoniumhexafluorophosphat, Di-(2-benzothienyl)-iodoniumhexafluorophosphat, Diaryliodoniumtristrifluormethylsulfonylmethid wie Diphenyliodoniumhexafluoroantimonat, Diaryliodoniumtetrakis-(pentafluorophenyl)-borat wie Diphenyliodoniumtetrakis-(pentafluorophenyl)-borat" (4-n-Desiloxyphenyl)-phenyliodoniumhexafluoroantimonat, [4-(2-Hydroxy-n-tetradesiloxy)-phenyl]-phenyliodoniumhexafluoroantimonat, [4-(2-Hydroxy-n-tetradesiloxy)-phenyl]-phenyliodoniumtrifluorosulfonat, [4-(2-Hydroxy-n-tetradesiloxy)-phenyl]-phenyliodoniumhexafluorophosphat, [4-(2-Hydroxy-n-tetradesiloxy)-phenyl]-phenyliodoniumtetrakis-(pentafluorophenyl)-borat, Bis-(4-tert-butylphenyl)-iodoniumhexafluoroantimonat, Bis-(4-tert-butylphenyl)-iodoniumhexafluorophosphat, Bis-(4-tert-butylphenyl)-iodoniumtrifluorosulfonat, Bis-(4-tert-butylphenyl)-iodoniumtetrafluoroborat, Bis-(dodecylphenyl)-iodoniumhexafluoroantimonat, Bis-(dodecylphenyl)-iodoniumtetrafluoroborat, Bis-(dodecylphenyl)-iodoniumhexafluorophosphat, Bis-(dodecylphenyl)-iodoniumtrifluoromethylsulfonat, Di-(dodecylphenyl)-iodoniumhexafluoroantimonat, Di-(dodecylphenyl)-iodoniumtriflat, Diphenyliodoniumbisulfat, 4,4'-Dichlorodiphenyliodoniumbisulfat, 4,4'-Dibromodiphenyliodoniumbisulfat, 3,3'-Dinitrodiphenyliodoniumbisulfat, 4,4'-Dimethyldiphenyliodoniumbisulfat, 4,4'-Bis-succinimidodiphenyliodoniumbisulfat, 3-Nitrodiphenyliodoniumbisulfat, 4,4'-Dimethoxydiphenyliodoniumbisulfat, Bis-(dodecylphenyl)-iodoniumtetrakis-(pentafluorophenyl)-borat, (4-Octyloxyphenyl)-phenyliodoniumtetrakis-(3,5-bis-trifluoromethylphenyl)-borat und (Tolylcumyl)-iodoniumtetrakis-(pentafluorophenyl)-borat,
   und
- Ferrocenium-Salze (siehe zum Beispiel EP 542 716 B1) wie n₅-(2,4-cyclopentadien-1-yl)-[(1,2,3,4,5,6,9)-(1-methylethyl)-benzol]-eisen.

Beispiele für kommerzialisierte Photoinitiatoren sind Cyracure UVI-6990, Cyracure UVI-6992, Cyracure UVI-6974 und Cyracure UVI-6976 der Firma Union Carbide, Optomer SP-55, Optomer SP-150, Optomer SP-151, Optomer SP-170 und Optomer SP-172 der Firma Adeka, San-Aid SI-45L, San-Aid SI-60L, San-Aid SI-80L, San-Aid SI-100L, San-Aid SI-110L, San-Aid SI-150L und San-Aid SI-180L der Firma Sanshin Chemical, SarCat CD-1010, SarCat CD-1011 und SarCat CD-1012 der Firma Sartomer, Degacure K185 der Firma Degussa, Rhodorsil Photoinitiator 2074 der Firma Rhodia, CI-2481, CI-2624, CI-2639, CI-2064, CI-2734, CI-2855, CI-2823 und CI-2758 der Firma Nippon Soda, Omnicat 320, Omnicat 430, Omnicat 432, Omnicat 440, Omnicat 445, Omnicat 550, Omnicat 550 BL und Omnicat 650 der Firma IGM Resins, Daicat II der Firma Daicel, UVAC 1591 der Firma Daicel-Cytec, FFC 509 der Firma 3M, BBI-102, BBI-103, BBI-105, BBI-106, BBI-109, BBI-110, BBI-201, BBI, 301, BI-105, DPI-105, DPI-106, DPI-109, DPI-201, DTS-102, DTS-103, DTS-105, NDS-103, NDS-105, NDS-155, NDS-159, NDS-165, TPS-102, TPS-103, TPS-105, TPS-106, TPS-109, TPS-1000, MDS-103, MDS-105, MDS-109, MDS-205, MPI-103" MPI-105, MPI-106, MPI-109, DS-100, DS-101, MBZ-101, MBZ-201, MBZ-301, NAI-100, NAI-101, NAI-105, NAI-106, NAI-109, NAI-1002, NAI-1003, NAI-1004, NB-101, NB-201, NDI-101, NDI-105, NDI-106, NDI-109, PAI-01, PAI-101, PAI-106, PAI-1001, PI-105, PI-106, PI-109, PYR-100, SI-101, SI-105, SI-106 und SI-109 der Firma Midori Kagaku, Kayacure PCI-204, Kayacure PCI-205, Kayacure PCI-615, Kayacure PCI-625, Kayarad 220 und Kayarad 620, PCI-061T, PCI-062T, PCI-020T, PCI-022T der Firma Nippon Kayaku, TS-01 und TS-91 der Firma Sanwa Chemical, Deuteron UV 1240 der Firma Deuteron, Tego Photocompound 1465N der Firma Evonik, UV 9380 C-D1 der Firma GE Bayer Silicones, FX 512 der Firma Cytec, Silicolease UV Cata 211 der Firma Bluestar Silicones und Irgacure 250, Irgacure 261, Irgacure 270, Irgacure PAG 103, Irgacure PAG 121, Irgacure PAG 203, Irgacure PAG 290, Irgacure CGI 725, Irgacure CGI 1380, Irgacure CGI 1907 und Irgacure GSID 26-1 der Firma BASF.

Dem Fachmann sind weitere Systeme bekannt, die ebenfalls erfindungsgemäß einsetzbar sind. Photoinitiatoren werden unkombiniert oder als Kombination von zwei oder mehreren Photoinitiatoren eingesetzt.

Vorteilhaft sind Photoinitiatoren, die Absorption bei kleiner 350 nm und vorteilhaft bei größer 250 nm aufweisen. Initiatoren, die oberhalb 350 nm absorbieren, beispielsweise im Bereich violetten Lichts, sind ebenfalls einsetzbar. Sulfonium-basierende Photoinitiatoren werden besonders bevorzugt eingesetzt, da sie eine vorteilhafte UV-Absorptionscharakteristik aufweisen.

Des Weiteren können Photosensitizer eingesetzt werden, die in einem Redox-Prozess den Photoinitiator reduzieren. In diesem Prozess wird der eigentliche Photoinitiator zersetzt, wobei reaktive Kationen gebildet werden, die eine kationische Polymerisation starten können. Diese Art der Reaktionsführung erlaubt die Initiation der kationischen Polymerisation bei höheren Wellenlängen. Beispiele für solche Photosensitizer sind Diphenolmethanon und Derivate, Acetophenonderivate wie beispielsweise Irgacure 651, Anthracenderivate wie 2-Ethyl-9,10-Dimethoxy-Anthracen und 9-Hydroxymethyl-Anthracen, Phenylketonderivate wie 1-Hydroxycyclohexyl-phenylketon, 2-Hydroxy-2-methyl-1-phenyl-propan-1-one und 4-(2-Hydroxyethoxy)-phenyl-(2-hydroxy-2-methylpropyl)-keton (Irgacure 184, Darocur 1173, Irgacure 2959) sowie Thioxanthenonderivate wie 4-Isopropyl-9-thioxanthenon oder 1-chloro-4-propoxy-thioxanthenon.

Besonders bevorzugte Kombinationen aus Photoinitiator und Sensitizer berücksichtigen die unterschiedlichen Redoxpotentiale und Retardierungspotentiale von Zwischenprodukten wie es für Kombinationen aus Diaryliodonium basierten Photoinitiatoren mit Acetophenonsensitizern der Fall ist und in Bulut U., Crivello J. V., J. Polym. Sci. 2005, 43, Seiten 3205 bis 3220, beschrieben ist.

Die Kombination von Styrolblockcopolymeren mit den besonders bevorzugten Weichblöcken und den bevorzugten Reaktivharzen zeigt vielfach eine gute Verträglichkeit im Hinblick auf die Bildung der homogenen Mischung.

In Fällen einer weniger guten Verträglichkeit, ist es vorteilhaft, einen Kompatibilisator zu verwenden. Dabei wird bevorzugt ein Kompatibilisator verwendet, der mit beiden Komponenten mischbar ist, aber selbst nicht mit einer der beiden Konstituenten während der Aufbaureaktion(en) des IPN reagiert. Dies erleichtert das Erreichen der erfindungsgemäßen Struktur, da bei der Steuerung der Ausbildung der erfindungsgemäßen Struktur kein weiterer Reaktionspartner beachtet werden muss. Möglich ist aber auch ein reaktiver Kompatibilisator.

Als Kompatibilisatoren werden häufig Block-Copolymere eingesetzt, deren einer Block mit dem einen Konstituenten und deren anderer Block mit dem anderen Konstituenten verträglich ist. Es hat sich herausgestellt, dass zur Ausbildung der erfindungsgemäßen Struktur vorteilhaft ein Kompatibilisator eingesetzt wird, der nicht auf einem BlockCopolymer basiert. Der für das Reaktivharz kompatible Block schränkt aufgrund seiner hohen Philie zur Reaktivkomponente dessen Diffusionsfähigkeit ein, so dass die Ausbildung einer erfindungsgemäßen Struktur erschwert wird. Eine ausreichende Diffusion ist aber notwendig, damit die Reaktivkomponente zu den dezidiert gesetzten Reaktionszentren gelangen kann.

Überraschend geeignet sind als Kompatibilisatoren Klebharze, wie sie dem Fachmann zum Beispiel aus dem Satas bekannt sind.

Besonders vorteilhaft enthält die Haftklebemasse zumindest eine Sorte eines vorzugsweise zumindest teilhydrierten Klebharzes, vorteilhaft solche, die mit der Elastomerkomponente beziehungsweise, sofern ein aus Hart- und Weichblöcken aufgebautes Copolymer eingesetzt wird, hauptsächlich mit dem Weichblock verträglich sind (Weichharze).
Es ist vorteilhaft, wenn entsprechendes Klebharz eine Erweichungstemperatur gemessen mittels Ring&Ball-Methode von größer 25 °C aufweist. Es ist darüber hinaus vorteilhaft, wenn ergänzend zumindest eine Sorte Klebharz mit einer Erweichungstemperatur von kleiner 20 °C eingesetzt wird. Hierüber kann, falls erforderlich, zum einen das klebtechnische Verhalten, zum anderen aber auch das Auffließverhalten auf dem Verklebungsuntergrund feineingestellt werden.

Für eher unpolare Elastomere können als Harze in der Haftklebemasse vorteilhaft partiell oder vollständig hydrierte Harze auf Basis von Kolophonium und Kolophoniumderivaten, hydrierte Polymerisate des Dicyclopentadiens, partiell, selektiv oder vollständig hydrierte Kohlenwasserstoffharze auf Basis von C₅-, C₅/C₉- oder C₉-Monomerströmen, Polyterpenharze auf Basis von α-Pinen und/oder β-Pinen und/oder δ-Limonen und/oder Δ³-Caren, hydrierte Polymerisate von bevorzugt reinen C₈- und C₉-Aromaten. Vorgenannte Klebharze können sowohl allein als auch im Gemisch eingesetzt werden. Dabei können sowohl bei Raumtemperatur feste als auch flüssige Harze zum Einsatz kommen. Um eine hohe Alterungs- und UV-Stabilität zu gewährleisten, sind hydrierte Harze mit einem Hydrierungsgrad von mindestens 90 %, vorzugsweise von mindestens 95 % bevorzugt.

Für polare Elastomere sind polare Harze als kompatibel dem Fachmann bekannt, beispielsweise Terpenphenol oder Kolophonium basierende Harze, wie ebenfalls aus dem Satas entnommen werden kann.

Die Herstellung der homogenen Mischung kann in der Substanz, in Lösung oder in der Schmelze erfolgen. Ausreichendes Kennzeichen für das Vorliegen einer homogenen Mischung ist, dass die Mischung optisch klar, also nicht getrübt, erscheint. In der Lösung wird dabei das Erscheinungsbild bei Raumtemperatur bewertet, in der Schmelze oder der Substanz das bei der Herstellungstemperatur der Mischung.

Trübungen durch weitere Inhaltstoffe der Mischung, zum Beispiel durch Antiblockmittel in den Elastomeren, werden dabei nicht betrachtet. Solche können gegebenenfalls abzentrifugiert oder abfiltriert werden, um die Mischung auf Homogenität zu überprüfen.

Bevorzugt erfolgt die Herstellung der Mischung in Lösung, da hierbei leichter eine homogene Verteilung erreicht werden kann. Die Auswahl der Lösemittel orientiert sich an den Konstituenten. Bevorzugt ist eine Kombination von zumindest zwei Lösemitteln, von denen das eine eine Löslichkeitsparameterdifferenz von nicht mehr als 3 (J/MPa)^{1/2} zu dem Löslichkeitsparameter des einen Konstituenten und das andere eine Löslichkeitsparameterdifferenz von nicht mehr als 3 (J/MPa)^{1/2} zu dem Löslichkeitsparameter des anderen Konstituenten aufweist.

Es werden die Löslichkeitsparameter (Hildebrandt-Parameter) bei 25 °C herangezogen. Da die Messung sehr aufwändig ist, werden die Werte dem Handbook of Solubility Parameters and Other Cohesion Parameters entnommen (Allan F.M.Barton: CRC Handbook of Solubility Parameters and Other Cohesion Parameters, CRC Press, 1991 ). Sofern Löslichkeitsparameter darin nicht experimentell ermittelt vorliegen, werden sie nach der Group-Contribution-Methode von Stefanis-Panayiotou berechnet (Int.J.Thermophys 2008, Vol. 29 Seiten 568 bis 585).

Die Herstellung von Schichten und Klebebändern erfolgt nach dem Mischen der Formulierung und vor der Durchführung der Aufbaureaktion. Die Herstellung von Schichten kann in Substanz, in Lösung oder in der Schmelze mit den Verfahren erfolgen, die dem Fachmann zur Herstellung von Schichtkörpern, insbesondere von Klebemasseschichten, bekannt sind.

Besonders vorteilhaft lässt sich die erfindungsgemäße Klebemasse in einem ein- oder doppelseitig klebenden Klebeband verwenden. Diese Darreichungsart erlaubt eine besonders einfache und gleichmäßige Applikation der Klebemasse. Die Herstellung des Klebebands erfolgt dabei vor der Ausführung der Aufbaureaktion.

Der Klebemasse können übliche Zuschlagstoffe wie Alterungsschutzmittel (Antiozonantien, Antioxidantien, Lichtschutzmittel usw.) zugesetzt sein.
Als Additive zur Klebemasse werden typischerweise genutzt:
- Plastifizierungsmittel wie zum Beispiel Weichmacheröle oder niedermolekulare flüssige Polymere wie zum Beispiel niedermolekulare Polybutene
- primäre Antioxidantien wie zum Beispiel sterisch gehinderte Phenole
- sekundäre Antioxidantien wie zum Beispiel Phosphite oder Thioether
- Prozessstabilisatoren wie zum Beispiel C-Radikalfänger
- Lichtschutzmittel wie zum Beispiel UV-Absorber oder sterisch gehinderte Amine
- Verarbeitungshilfsmittel
- Netzadditive
- Haftvermittler
- Endblockverstärkerharze und/oder
- gegebenenfalls weitere Polymere von bevorzugt elastomerer Natur; entsprechend nutzbare Elastomere beinhalten unter anderem solche auf Basis reiner Kohlenwasserstoffe, zum Beispiel ungesättigte Polydiene wie natürliches oder synthetisch erzeugtes Polyisopren oder Polybutadien, chemisch im wesentlichen gesättigte Elastomere wie zum Beispiel gesättigte Ethylen-Propylen-Copolymere, α-Olefincopolymere, Polyisobutylen, Butylkautschuk, Ethylen-Propylenkautschuk, sowie chemisch funktionalisierte Kohlenwasserstoffe wie zum Beispiel halogenhaltige, acrylathaltige, allyl- oder vinyletherhaltige Polyolefine

Die Zuschlagstoffe oder Additive sind nicht zwingend, die Klebemasse funktioniert auch, ohne dass diese einzeln oder in beliebiger Kombination zugesetzt sind.

Füllstoffe können vorteilhaft in den erfindungsgemäßen Haftklebemassen eingesetzt werden. Bevorzugt werden als Füllstoffe der Klebmasse nanoskalige und/oder transparente Füllstoffe verwendet. Als nanoskalig wird ein Füllstoff vorliegend bezeichnet, wenn er in mindestens einer Dimension eine maximale Ausdehnung von etwa 100 nm, bevorzugt von etwa 10 nm, aufweist. Besonders bevorzugt werden solche in der Masse transparente Füllstoffe mit plättchenförmiger Kristallitstruktur und einem hohen Aspektverhältnis bei homogener Verteilung verwendet. Die Füllstoffe mit plättchenartiger Kristallitstruktur und Aspektverhältnissen weit über 100 haben in der Regel nur eine Dicke von einigen nm, die Länge beziehungsweise die Breite der Kristallite kann aber bis zu einigen µm betragen. Derartige Füllstoffe werden ebenfalls als Nanopartikel bezeichnet. Die partikuläre Ausgestaltung der Füllstoffe mit kleinen Abmessungen ist zudem besonders vorteilhaft für eine transparente Auslegung der Haftklebemasse.

Die Füllstoffe sind nicht zwingend, die Klebemasse funktioniert auch, ohne dass diese einzeln oder in beliebiger Kombination zugesetzt sind.

Vorzugsweise ist die erfindungsgemäße Haftklebemasse im angegebenen Sinne transparent.

"Transparenz" bedeutet dabei eine mittlere Transmission der Klebemasse im sichtbaren Bereich des Lichts von mindestens 75 %, bevorzugt höher als 80 %, weiter bevorzugt höher als 88 %, wobei sich diese Betrachtung auf unkorrigierte Transmission, also ohne Grenzflächenreflexionsverluste herauszurechnen, bezieht.

Vorzugsweise zeigt die Klebemasse einen Haze kleiner 5,0 %, bevorzugt kleiner 2,5 %.

Die Herstellung und Verarbeitung der Haftklebemasse kann aus Lösung, Dispersion sowie aus der Schmelze erfolgen. Bevorzugt erfolgt die Herstellung und Verarbeitung aus Lösung oder aus der Schmelze. Besonders bevorzugt ist die Fertigung der Klebmasse aus Lösung. Dabei werden die Bestandteile der Haftklebemasse in einem geeigneten Lösungsmittel, zum Beispiel Toluol oder Mischungen aus Benzin und Aceton, gelöst und mit allgemein bekannten Verfahren auf den Träger aufgebracht. Bei der Verarbeitung aus der Schmelze können dies Auftragsverfahren über eine Düse oder einen Kalander sein. Bei Verfahren aus der Lösung sind Beschichtungen mit Rakeln, Messern, Walzen oder Düsen bekannt, um nur einige zu nennen.
Über die Beschichtungstemperatur kann in lösungsmittelfreien Prozessen das Beschichtungsergebnis beeinflusst werden. Dem Fachmann sind die Prozessparameter geläufig, um transparente Klebeschichten zu erhalten. In Lösungsmittelbeschichtungsprozessen kann über die Auswahl des Lösungsmittels oder des Lösungsmittelgemischs das Beschichtungsergebnis beeinflusst werden. Dem Fachmann ist auch hier geläufig, geeignete Lösungsmittel auszuwählen. Kombinationen aus insbesondere unpolaren Lösungsmitteln, die unter 100 °C sieden, mit Lösungsmitteln, die oberhalb 100 °C sieden, insbesondere aromatische, sind sehr gut geeignet.

Vorteilhaft ist die Beschichtung aus Lösungsmitteln oder aus der Schmelze. Hierfür bieten erfindungsgemäße Formulierungen große Vorteile, wie bereits weiter oben ausgeführt wurde.

Besonders vorteilhaft lässt sich die erfindungsgemäße Klebemasse in einem ein- oder doppelseitig klebenden Klebeband verwenden. Diese Darreichungsart erlaubt eine besonders einfache und gleichmäßige Applikation der Klebemasse.

Bei einem doppelseitigen Klebeband kann beidseitig die erfindungsmäße Haftklebemasse auf dem Träger aufgebracht sein (mit identischer oder unterschiedlicher Zusammensetzung), oder es kann auf einer der beiden Seiten eine andere als die erfindungsgemäße, dem jeweiligen Anwendungszweck besonders angepasste Klebemasse vorhanden sein.

Vorzugsweise enthält das Klebeband eine Schicht der erfindungsgemäßen Haftklebemasse oder es besteht aus einer einzigen oder mehreren Schichten der erfindungsgemäßen Haftklebemasse.

Der allgemeine Ausdruck "Klebeband" umfasst dabei ein Trägermaterial, welches ein- oder beidseitig mit einer (Haft)klebemasse versehen ist. Das Trägermaterial umfasst alle flächigen Gebilde, beispielsweise in zwei Dimensionen ausgedehnte Folien oder Folienabschnitte, Bänder mit ausgedehnter Länge und begrenzter Breite, Bandabschnitte, Stanzlinge (beispielsweise in Form von Umrandungen oder Begrenzungen einer (opto-)elektronischen Anordnung), Mehrschichtanordnungen und dergleichen. Dabei sind für verschiedene Anwendungen unterschiedlichste Träger wie zum Beispiel Folien, Gewebe, Vliese und Papiere mit den Klebmassen kombinierbar. Des Weiteren umfasst der Ausdruck "Klebeband" auch so genannte "Transferklebebänder", das heißt ein Klebeband ohne Träger. Bei einem Transferklebeband ist die Klebemasse vielmehr vor der Applikation zwischen flexiblen Linern aufgebracht, die mit einer Trennschicht versehen sind und/oder anti-adhäsive Eigenschaften aufweisen. Zur Applikation wird regelmäßig zunächst ein Liner entfernt, die Klebemasse appliziert und dann der zweite Liner entfernt. Die Klebemasse kann so direkt zur Verbindung zweier Oberflächen in (opto-)elektronischen Anordnungen verwendet werden.
Es sind aber auch Klebebänder möglich, bei denen nicht mit zwei Linern sondern mit einem einzigen doppelseitig trennend ausgerüstet Liner gearbeitet wird. Die Klebebandbahn ist dann an ihrer Oberseite mit der einen Seite eines doppelseitig trennend ausgerüsteten Liners abgedeckt, ihre Unterseite mit der Rückseite des doppelseitig trennend ausgerüsteten Liners, insbesondere einer benachbarten Windung auf einem Ballen oder einer Rolle.

Als Trägermaterial eines Klebebandes werden vorliegend bevorzugt Polymerfolien, Folienverbunde oder mit organischen und/oder anorganischen Schichten versehene Folien oder Folienverbunde eingesetzt. Derartige Folien/Folienverbunde können aus allen gängigen zur Folienherstellung verwendeten Kunststoffen bestehen, beispielhaft aber nicht einschränkend erwähnt seien:
Polyethylen, Polypropylen - insbesondere das durch mono-oder biaxiale Streckung erzeugte orientierte Polypropylen (OPP), Cyclische Olefin Copolymere (COC), Polyvinylchlorid (PVC), Polyester - insbesondere Polyethylenterephthalat (PET) und Poylethylennaphtalat (PEN), Ethylenvinylalkohol (EVOH), Polyvinylidenchlorid (PVDC), Polyvinylidenfluorid (PVDF), Polyacrylnitril (PAN), Polycarbonat (PC), Polyamid (PA), Polyethersulfon (PES) oder Polyimid (PI).

Bei doppelseitig (selbst)klebenden Klebebändern können als obere und untere Schicht erfindungsgemäße Klebemassen gleicher oder verschiedener Art und/oder gleicher oder verschiedener Schichtdicke zur Anwendung kommen. Der Träger kann dabei auf einer oder beiden Seiten dem Stand der Technik entsprechend vorbehandelt sein, so dass beispielsweise eine Verbesserung der Klebemassenverankerung erzielt wird. Ebenso können eine oder beide Seiten mit einer funktionalen Schicht ausgerüstet sein, die beispielsweise als Sperrschicht fungieren kann. Die Haftklebemasseschichten können optional mit Trennpapieren oder Trennfolien eingedeckt werden. Alternativ kann auch nur eine Klebemasseschicht mit einem doppelseitig trennenden Liner eingedeckt sein.
In einer Variante ist in dem doppelseitig (selbst)klebenden Klebeband eine erfindungsgemäße Klebemasse vorgesehen sowie eine beliebige weitere, zum Beispiel eine solche, die besonders gut auf einem Abdecksubstrat haftet oder eine besonders gute Repositionierbarkeit zeigt.

Die Dicke der Haftklebemasse, die entweder als Transferklebeband oder auf einem flächigen Gebilde beschichtet vorliegt, beträgt bevorzugt zwischen 1 µm und 2000 µm, weiter bevorzugt zwischen 5 µm und 500 µm und besonders bevorzugt zwischen etwa 12 µm und 250 µm.
Schichtdicken zwischen 50 µm und 150 µm werden dann eingesetzt, wenn eine verbesserte Haftung auf dem Substrat und/oder eine dämpfende Wirkung erreicht werden soll.
Schichtdicken zwischen 1 µm und 50 µm reduzieren den Materialeinsatz. Jedoch kommt es zu einer Verringerung der Haftung aus dem Substrat.

Für doppelseitige Klebebänder gilt für die Klebemasse(n) ebenfalls, dass die Dicke der einzelnen Haftklebemasseschicht(en) bevorzugt 1 µm und 2000 µm, weiter bevorzugt zwischen 5 µm und 500 µm und besonders bevorzugt zwischen etwa 12 µm und 250 µm liegt. Kommt in doppelseitigen Klebebändern neben der einen erfindungsgemäßen Klebemasse eine weitere zum Einsatz, dann kann es auch vorteilhaft sein, wenn ihre Dicke oberhalb 150 µm liegt.

Besonders vorteilhaft ist die Verwendung des erfindungsgemäßen Haftklebebandes in folgenden Anwendungen:
- Haftklebemassen mit hoher Permeationsbarriere:
   Insbesondere die Kombination von unpolarem Elastomer mit einem reaktiven Konstituenten führt zu Haftklebemassen mit besonders erhöhter Permeationsbarriere. Die Klebemasse sowie ein eventuell damit gebildetes Klebeband ist hervorragend zur Kapselung einer elektronischen Anordnung, insbesondere einer organischen elektronischen Anordnung, gegen Permeate geeignet, indem die Klebemasse oder das Klebeband auf und/oder um die zu kapselnden Bereiche der elektronischen Anordnung appliziert werden. Auch Verwendungen im Bereich der Verpackung, insbesondere von zum Beispiel Pharmazeutika, ist vorteilhaft. Die besondere Struktur aus verbundenen Partikeln erschwert die Permeation von Wasserdampf durch die polarere Hartphase infolge der geometrischen Einschnürungen zwischen den Partikeln. Die Hartphase bildet aber dennoch ein dichtes Netzwerk, welches die Permeation von leichteren Gasen, wie zum Beispiel Sauerstoff, erheblich verringert.
- Haftklebemassen für strukturelle Verklebungen
   Durch die hohe Fließfähigkeit in dem Zustand, in dem die Aufbaureaktion noch nicht stattgefunden hat (ergibt hohe Adhäsion durch verbesserten Kontakt zum Substrat) und das dichte und feingliedrige Netzwerk nach Herstellung der erfindungsgemäßen Struktur (hohe Kohäsion), welches eine hohe Scherfestigkeit aufweist, eignen sich die Haftklebemassen besonders zur Herstellung von strukturellen Verklebungen, insbesondere wenn eine Verklebungsfestigkeit von mehr als 200 N/cm² im dynamischen Schertest gefordert ist.

Im Folgenden wird die Erfindung durch einige Beispiele näher erläutert, ohne die Erfindung damit einschränken zu wollen.

### Prüfmethoden

Sofern nichts anderes angegeben ist, werden alle Messungen bei 23 °C und 50 % relativer Luftfeuchte durchgeführt.

### Klebkraft

Die Klebkräfte auf Stahl wurden analog ISO 29862 (Methode 3) bei 23 °C und 50 % relativer Luftfeuchte bei einer Abzugsgeschwindigkeit von 300 mm/min und einem Abzugswinkel von 180° bestimmt. Als Verstärkungsfolie wurde eine geätzte PET-Folie mit einer Dicke von 50 µm verwendet, wie sie von der Firma Coveme (Italien) erhältlich ist. Die Verklebung des Messtreifens wurde dabei mittels einer Anrollmaschine bei einer Temperatur von 23 °C vorgenommen. Die Klebebänder wurden sofort nach der Applikation abgezogen. Der Messwert (in N/cm) ergab sich als Mittelwert aus drei Einzelmessungen. Die Prüfung erfolgte an unvernetzten Mustern

### Permeabilität für Sauerstoff (OTR) und Wasserdampf (WVTR)

Die Bestimmung der Permeabilität für Sauerstoff (OTR) und Wasserdampf (WVTR) erfolgt nach DIN 53380 Teil 3 beziehungsweise ASTM F-1249. Die Haftklebemasse wird dazu mit einer Schichtdicke von 50 µm auf eine permeable Membran aufgebracht. Die Sauerstoffdurchlässigkeit wird bei 23 °C und einer relativen Feuchte von 50 % gemessen. Die Wasserdampfdurchlässigkeit wird bei 38°C und einer relativen Feuchte von 90 % bestimmt. Die Prüfung erfolgte an vernetzten Mustern.

### Zugversuch

Als Kenngröße für die Kohäsion des erfindungsgemäßen IPN wurde die Zug-DehnungsKurve analog DIN-EN-ISO 527-3 ermittelt. Hierzu wurden Prüfkörper (Form analog Typ 2: Messlänge 30 mm, Breite 4 mm) bei 23 °C mit einer Prüfgeschwindigkeit von 300 mm/min mit variierendem Epoxidgehalt untersucht. Die Prüfung erfolgte an vernetzten Mustern

### Klebharzenweichungstemperatur

Die Klebharzerweichungstemperatur wird nach der einschlägigen Methodik durchgeführt, die als Ring & Ball bekannt ist und nach ASTM E28 standardisiert ist.

Zur Bestimmung der Klebharzerweichungstemperatur der Harze kommt ein Ring-Kugel-Automat HRB 754 der Firma Herzog zum Einsatz. Harzmuster werden zunächst fein gemörsert. Das resultierende Pulver wird in einen Messingzylinder mit Bodenöffnung (Innendurchmesser am oberen Teil des Zylinders 20 mm, Durchmesser der Bodenöffnung des Zylinders 16 mm, Höhe des Zylinders 6 mm) gefüllt und auf einem Heiztisch geschmolzen. Die Befüllmenge wird so gewählt, dass das Harz nach dem Schmelzen den Zylinder ohne Überstand voll ausfüllt.

Der resultierende Probekörper wird samt Zylinder in die Probehalterung des HRB 754 eingelegt. Zur Befüllung des Temperierbads wird Glycerin verwendet, sofern die Klebharzerweichungstemperatur zwischen 50 °C und 150 °C liegt. Bei niedrigeren Klebharzerweichungstemperaturen kann auch mit einem Wasserbad gearbeitet werden. Die Prüfkugeln haben einen Durchmesser von 9,5 mm und wiegen 3,5 g. Entsprechend der HRB 754 Prozedur wird die Kugel oberhalb des Probekörpers im Temperierbad angeordnet und auf dem Probekörper abgelegt. 25 mm unter dem Zylinderboden befindet sich eine Auffangplatte, 2 mm über dieser eine Lichtschranke. Während des Messvorgangs wird die Temperatur mit 5 °C/min erhöht. Im Temperaturbereich der Klebharzerweichungstemperatur beginnt sich die Kugel durch die Bodenöffnung des Zylinders zu bewegen, bis sie schließlich auf der Auffangplatte zum Stehen kommt. In dieser Position wird sie von der Lichtschranke detektiert und zu diesem Zeitpunkt die Temperatur des Temperierbads registriert. Es findet eine Doppelbestimmung statt. Die Klebharzerweichungstemperatur ist der Mittelwert aus den beiden Einzelmessungen.

### Erweichungstemperatur

Die Erweichungstemperatur von Homopolymeren, Copolymeren, Hart- und Weichblöcken und ungehärteten Reaktivharzen wird kalorimetrisch über die Differential Scanning Calorimetry (DSC) nach DIN 53765:1994-03 bestimmt. Aufheizkurven laufen mit einer Heizrate von 10 K/min. Die Muster werden in AI-Tiegeln mit gelochtem Deckel und Stickstoffatmosphäre vermessen. Es wird die zweite Aufheizkurve ausgewertet. Bei amorphen Stoffen werden die auftretenden Glasübergangstemperaturen als Erweichungstemperatur definiert, bei (semi)kristallinen Stoffen die Schmelztemperaturen. Ein Glasübergang ist als Stufe im Thermogramm erkennbar. Die Glasübergangstemperatur wird als Mittelpunkt dieser Stufe ausgewertet. Eine Schmelztemperatur ist als Peak im Thermogramm erkennbar. Als Schmelztemperatur wird diejenige Temperatur notiert, bei der die höchste Wärmetönung auftritt.

### Transmission

Die Transmission der Klebemasse wurde analog ASTM D1003-11 (Procedure A (Hazemeter Byk Haze-gard Dual), Normlichtart D65) bestimmt. Eine Korrektur von Grenzflächenreflextionsverlusten wird nicht vorgenommen. Die Prüfung erfolgte an vernetzten Mustern mit einer Dicke von etwa 50 µm.

### HAZE-Messung

Der HAZE-Wert beschreibt den Anteil des transmittierten Lichts, der von der durchstrahlten Probe nach vorne großwinklig gestreut wird. Somit quantifiziert der HAZE-Wert Materialfehler in der Oberfläche oder der Struktur, die die klare Durchsicht stören. Das Verfahren zur Messung des Haze-Wertes wird in der Norm ASTM D 1003 beschrieben. Die Norm erfordert die Messung von vier Transmissionsmessungen. Für jede Transmissionsmessung wird der Lichttransmissionsgrad berechnet. Die vier Transmissionsgrade werden zum prozentualen Haze-Wert verrechnet. Der HAZE-Wert wird mit einem Haze-gard Dual von Byk-Gardner GmbH gemessen. Die Prüfung erfolgte an vernetzten Mustern mit einer Dicke von etwa 50 µm.

### Molekulargewicht

Die Bestimmung des mittleren Molekulargewichtes M_{w} (Gewichtsmittel) erfolgt mittels Gelpermeationschromatographie (GPC). Als Eluent wird THF mit 0,1 Vol.-% Trifluoressigsäure eingesetzt. Die Messung erfolgt bei 25 °C. Als Vorsäule wird PSS-SDV, 5 µm, 10³ Å, ID 8,0 mm x 50 mm verwendet. Zur Auftrennung wurden die Säulen PSS-SDV, 5 µm, 10³ Å, 10⁵ Å und 10⁶ Å mit jeweils ID 8,0 mm × 300 mm eingesetzt. Die Probenkonzentration beträgt 4 g/l, die Durchflussmenge 1,0 ml pro Minute. Es wird gegen PS-Standards gemessen.

### Dynamischer Schertest

Ein Transferklebeband wird zwischen zwei Glasplatten (Floatglas) verklebt und mittels UV-Licht gehärtet. Nach einer Lagerung von 24 h wird der Verbund in der Zugprüfmaschine mit 50 mm/min bei 23 °C und 50% rel. Feuchte so getrennt, dass die beiden Glasplatten unter einem Winkel von 180° auseinander gezogen wurden, und die Maximalkraft in N/cm² ermittelt. Dabei wird ein quadratisches Prüfmuster mit einer Kantenlänge von 25 mm untersucht.

### MMAP

MMAP ist der gemischte-Methylcyclohexan-Anilin-Trübungspunkt, der unter Verwendung eines modifizierten ASTM C 611-Verfahrens bestimmt wird. Methylcyclohexan ist für das in dem Standard-Prüfverfahren verwendete Heptan eingesetzt. Das Verfahren verwendet Harz/Anilin/Methylcyclohexan in einem Verhältnis von 1/2/1 (5 g/10 ml/5 ml) und der Trübungspunkt wird durch Abkühlen einer erhitzten, klaren Mischung der drei Komponenten, bis die vollständige Trübung gerade eintritt, bestimmt

### DACP

Der DACP ist der Diaceton-Trübungspunkt und wird durch Abkühlen einer erhitzten Lösung von 5 g Harz, 5 g Xylol und 5 g Diacetonalkohol bis zu dem Punkt bestimmt, bei welchem die Lösung trübe wird.

Im Folgenden wird die Erfindung durch einige Beispiele näher erläutert, ohne die Erfindung damit einschränken zu wollen

### Beispiele

Sofern nicht anders angegeben, sind alle Mengenangaben in den nachfolgenden Beispielen Gewichtsprozente beziehungsweise Gewichtsteile bezogen auf die Gesamtzusammensetzung ohne Photoinitiator. Die Photoinitiatormenge bezieht sich auf die Menge des eingesetzten Konstituenten der durch die Aufbaureaktion zu erhaltenden Phase (hier Epoxidharz beziehungsweise Acrylatharz).

Verwendete Rohstoffe:

| | |
|---|---|
| Kraton G 1657 | SEBS mit 13 Gew.-% Blockpolystyrolgehalt der Firma Kraton Das SEBS enthielt 36 Gew.-% Zweiblockgehalt. |
| Uvacure 1500 | cycloaliphatisches Diepoxid der Firma Dow |
| Regalite R1100 | ein vollhydriertes Kohlenwasserstoffharz der Firma Eastman (Ring and Ball 100 °C, DACP = 45, MMAP = 82), |
| Triarylsulfoniumhexa-fluoroantimonat | kationischer Fotoinitiator von der Firma Sigma-Aldrich Der Photoinitiator weist ein Absorptionsmaximum im Bereich 320 nm bis 360 nm auf und lag als 50 Gew.-%-ige Lösung in Propylencarbonat vor |
| SR833s | Tricyclodecandimethanol Diacrylat der Firma Sartomer |
| Irgacure 500 | radikalischer Fotoinitiator von der Firma BASF |

| **Beispiel:** | **V2** | **V1** | **2** | **3** | **4** | **5** | **6** | **7** | **8** | **V9** |
|---|---|---|---|---|---|---|---|---|---|---|
| | Gew.- % | Gew.- % | Gew.- % | Gew.- % | Gew.- % | Gew.- % | Gew.- % | Gew.- % | Gew.- % | Gew.- % |
| Kraton G 1657 | 50 | 45 | 42,5 | 40 | 37,5 | 35 | 33,4 | 30 | 30 | 0 |
| Uvacure 1500 | 0 | 10 | 15 | 20 | 25 | 30 | 33,3 | 40 | 50 | 100 |
| Regalite R1100 | 50 | 45 | 42,5 | 40 | 37,5 | 35 | 33,3 | 30 | 20 | 0 |
| Triarylsulfoniumhexafluoroantimonat | 0 | 1 | 1 | 1 | 1 | 1 | 1 | 1 | 1 | 1 |

| **Vergleichsbeispiel:** | **V3** |
|---|---|
| | Gew.-% |
| Kraton G 1657 | 33,4 |
| SR833s | 33,3 |
| Regalite 1090 | 33,3 |
| Irgacure 500 | 3 |

Als Copolymer wurde für die Beispiele sowie Vergleichsbeispiele 1 und 2 ein SEBS mit 13 Gew.-% Blockpolystyrolgehalt der Firma Kraton ausgewählt. Es wurde Kraton G 1657 verwendet. Die Molmasse (Gewichtsmittel) beträgt etwa 120.000 g/mol für die Triblöcke.

Als Reaktivharz wurde in den Beispielen V1 sowie 2 bis 8 Uvacure 1500 der Firma Dow ausgewählt, ein cycloaliphatisches Diepoxid (3,4-Epoxycyclohexylmethyl 3,4-epoxycyclohexanecarboxylate). Die Glasübergangstemperatur von Uvacure 1500 betrug -53 °C.

Diese Rohstoffe wurden bei Raumtemperatur in einem Gemisch aus Toluol (300 Teile), Aceton (150 Teile) und Siedegrenzenbenzin 60/95 (550 Teile) gelöst, so dass eine 50 Gew.-% Lösung entsteht.

Anschließend wurde der Lösung der Photoinitiator zugesetzt.

In dem Vergleichsbeispiel 3 wurde der mittels einer kationischen Aufbaureaktion aufbauende Konstituent durch einen solchen ersetzt, der mittels einer freien radikalischen Aufbaureaktion aufbaut.

Als Reaktivharz wurde im Vergleichsbeispiel 3 SR833s der Firma Sartomer ausgewählt, ein cycloaliphatisches Diacrylat (Tricyclodecan dimethanol diacrylat).

Für das Vergleichsbeispiel 3 erfolgte die Herstellung analog den Beispielen.

Als **Vergleichsbeispiel 4** wurde Beispiel 5 aus der EP 2160443 B1 gewählt. Die Herstellung erfolgte analog zu den Angaben in dieser Schrift. Es ergab sich eine pastose Masse. Klebkraftmessungen konnten daher nicht durchgeführt werden. Diese Masse ist somit nicht als Klebemasse für ein Klebeband geeignet.

### Herstellung von Mustern:

Mittels eines Rakelverfahrens wurde die Formulierung aus Lösung auf einen silikonisierten PET-Liner beschichtet und bei 120 °C für 15 min getrocknet. Der Masseauftrag betrug 50 g/m². Die Muster wurden mit einer weiteren Lage eines silikonisierten aber leichter trennenden PET-Liners eingedeckt.

Aus diesen Mustern wurden Probekörper für Klebkraftmessungen erzeugt. Es wurden zudem Muster für dynamische Schertests erzeugt. Die Härtung erfolgte mit einer undotierten Mitteldruck-Quecksilberlampe mit einer UV-Dosis (Summe UV-A+B ermittelt mit dem Power Puck der Firma EIT) von 2000 mJ/cm².

Für Vergleichsbeispiel 4 wurde ein Prüfstab direkt mit der Masse in einer Dicke von 50 µm beschichtet, sodann mit dem zweiten Prüfstab in Kontakt gebracht und der Verbund für 6 h bei 70 °C im Ofen ausgehärtet.

Weiterhin wurden die Transmission und der Haze ermittelt. Die Ergebnisse sind in nachfolgender Tabelle zusammengefasst:

| **Beispiel** | **Klebkraft [N/cm]** | **dynamische Scherfestigkeit [N/cm²]** | **Transmission [%]** | **Haze** |
|---|---|---|---|---|
| **V1** | 6,9 | 40 | 92 | 1,2 |
| **2** | 7,4 | 110 | 92 | 1,4 |
| **3** | 6,4 | 150 | 91 | 1,3 |
| **4** | 6,1 | 160 | 91 | 1,2 |
| **5** | 5,5 | 250 | 91 | 1,3 |
| **6** | 5,5 | 270 | 91 | 1,4 |
| **7** | 5,0 | 310 | 92 | 1,6 |
| **8** | 4,2 | 240 | 89 | 3,1 |
| **V3** | 5,8 | 180 | 92 | 1,5 |
| **V4** | - | 140 | 90 | 2,6 |

Es zeigt sich, dass die dynamische Scherfestigkeit ab einer Konzentration von 15 % des reaktiven Konstituenten der Hartphase erheblich ansteigt. Dies kann auf das Ausbilden des Netzwerks aus verbundenen Nanopartikeln zurückgeführt werden, was auch in rasterelektronenmikroskopischen Aufnahmen zu beobachten war. In Vergleichsbeispiel V1 lagen lediglich vereinzelte Partikel oder Cluster von diesen vor, die aber nicht zu einem durchgehenden Netzwerk verbunden waren.

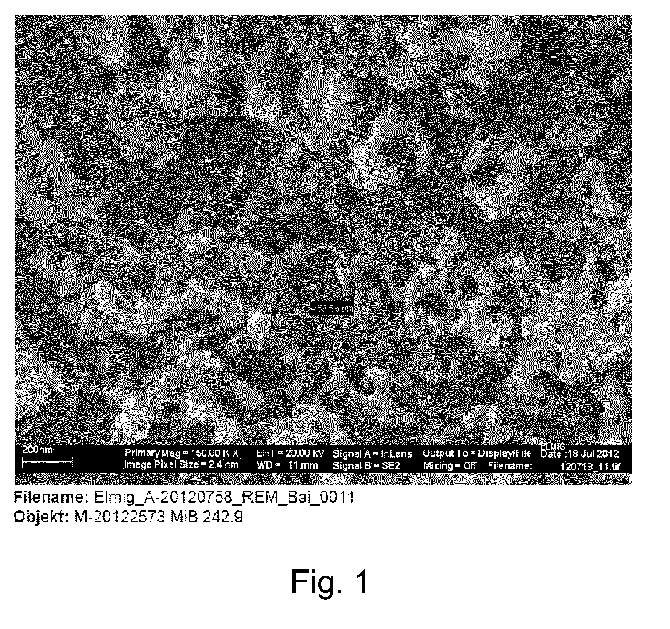

Figur 1 zeigt eine rasterelektronenmikroskopische Aufnahme von Beispiel 6. Die partikulären Hartphasen aus vernetztem Epoxid mit einer Größe um 50 nm bilden makroskopische Überstrukturen aus diesen Partikeln aus. Dieses verbundene Nanopartikelnetzwerk mit vielfältigen Durchbrüchen durchzieht die Klebemasse vollständig.

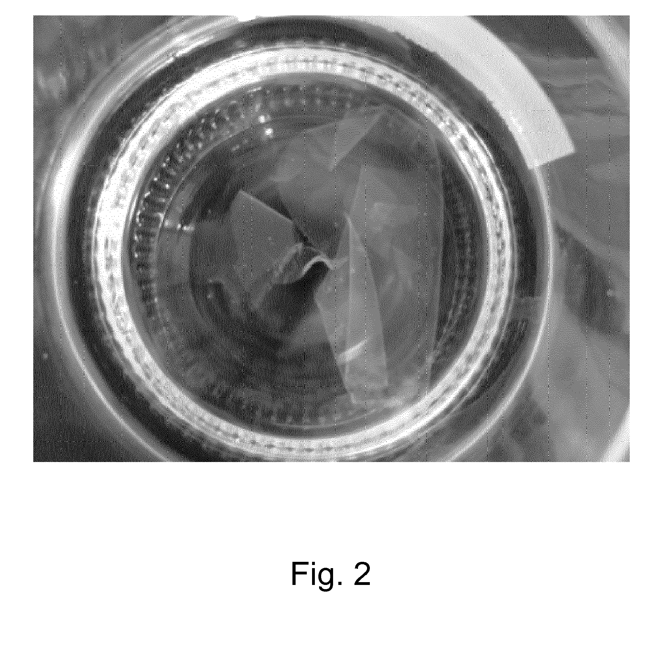

Die Vollständigkeit des Netzwerks wird besonders gut in der fotographischen Aufnahme in Figur 2 ersichtlich. Hier ist die Geometrie eines Klebefilms nach Beispiel 6 nach drei Monaten Extraktion in Toluol noch deutlich frei schwebend in dem Lösemittel zu erkennen. Die unvernetzte Elastomerphase und das Klebharz wurden in dieser Zeit vollständig extrahiert. Dies belegt eindeutig, dass die vernetzten - und damit unlöslichen - Partikel sich gegenseitig kontaktieren und eine durchgängige Überstruktur ausbilden. Wären die Partikel nicht untereinander verbunden, so würde sich der Klebefilm vollständig auflösen und als Geometrie nicht mehr optisch erkennbar sein. Diese Vollständigkeit des Netzwerks zeigt sich auch in den hohen Scherfestigkeiten bei diesem Beispiel.

Aufgrund des steigenden Anteils der Hartphase steigen die Scherfestigkeiten von Beispiel V1 bis Beispiel 7 an, wobei Transmission und Haze weitgehend gleich bleiben. Bei einer Konzentration von 50 % des reaktiven Konstituenten der Hartphase (Beispiel 8) fällt dann die Transmission leicht ab und der Haze-Wert steigt stark an. Dies deutet bereits auf einen Morphologiewandel hin. Rasterelektronische Aufnahmen lassen nur noch in Teilbereichen ein verbundenes Nanopartikelnetzwerk erkennen, in weiteren Bereichen ist keine innere Struktur der Hartphase mehr erkennbar. Die Hartphasendomänen werden bereichsweise wesentlich größer, bekannte kokontinuierliche Strukturen werden bereichsweise gebildet. Bereichsweise ist auch schon eine Phasenumkehr zu beobachten.

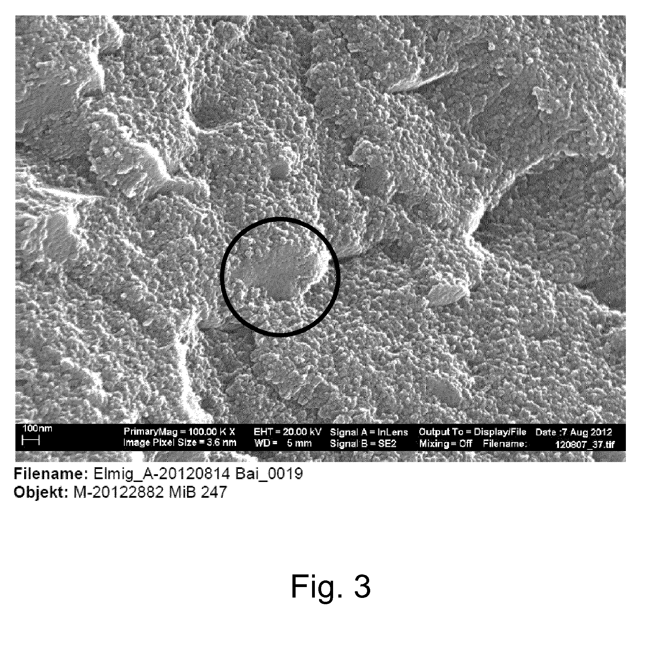

Im Vergleichsbeispiel V3 wird im Vergleich zum ähnlich zusammengesetzten Beispiel 6 eine wesentlich geringere Scherfestigkeit erreicht. Dies könnte darauf hindeuten, dass das Netzwerk nicht durchgehend verbunden ist. Elektronenmikroskopische Aufnahmen zeigen, dass Cluster aus kompakter Hartphase vorliegen (Figur 3), die eine wesentlich gröbere Dimension zeigen als das verbundene Nanopartikelnetzwerk. Durch die Präparation mittels Kryobruch ergibt sich die raue Bruchfläche, die nur vereinzelt einen Blick in das Innere der Struktur erlaubt (Kreismarkierung). Hier zeigt sich eine kompakte Struktur. Diese bildet sich durch die schnelle, unkontrollierte Vernetzung aus. Zusammenhängende Überstrukturen aus verbundenen Nanopartikeln bilden sich dementsprechend nicht unwillkürlich aus, sondern bevorzugt bei langsamer Reaktionsführung wie es zum Beispiel für kationische und kontrolliert radikalische Polymerisationen der Fall ist.

In Vergleichsbeispiel 4 liegt keine Haftklebemasse vor, die Zusammensetzung ist pastos. rasterelektronenmikroskopische Aufnahmen zeigen eine ähnliche Struktur wie bei Vergleichsbeispiel 3. Die schnelle radikalische Polymerisation führt auch hier zu einer gröberen und kompakteren Struktur. Transmission und Haze sind etwas schlechter als bei Vergleichsbeispiel 3, was auf die fehlende kompatibilisierende Wirkung des Klebharzes und den höheren Hartphasenanteil zurückgeführt wird. Dass trotzdem eine recht transparente Klebemasse erreicht wird, kann auf die bereits in EP 2160443 B1 angeführte Ähnlichkeit des Brechungsindexes der Hartphase zur Elastomerphase zurückgeführt werden.

### Ergebnisse der Permeationsmessung:

Nachstehende Tabelle zeigt die WVTR und die OTR für die Beispiele und Vergleichsbeispiele, wobei der Anteil der Hartphase von V2 über V1 bis zu Beispiel 8 stetig zunimmt und V9 die reine Hartphase repräsentiert.

| **Beispiel** | **OTR [cm³ m⁻²d⁻¹bar⁻¹]** | **WVTR [g m⁻²d⁻¹** |
|---|---|---|
| **V2** | 3400 | 24 |
| **V1** | 2913 | 26 |
| **3** | 2575 | 31 |
| **6** | 2041 | 38 |
| **8** | 1702 | 80 |
| **V9** | 242 | 123 |

Die OTR ist offensichtlich von den inneren Querschnittsflächenanteilen der Konstituenten abhängig, denn durch die Elastomerphase permeiert Sauerstoff wesentlich stärker als durch die Hartphase. Bei Variation des Epoxidgehaltes der IPNs zeigen die OTR-Werte einen nahezu linearen Zusammenhang (je mehr Epoxid, desto niedriger die OTR). Es gibt eine kontinuierliche Elastomerphase, durch die Sauerstoff migriert. Je mehr diese Phase von Epoxid verdrängt wird, desto kleiner wird die Durchtrittsfläche.

Das reine Elastomer-Harz-System hat bereits einen niedrigen WVTR von 24 g/m²d, das reine Epoxid (aufgrund seiner Polarität) einen sehr hohen von 123 g/m²d. Hier steigt der WVTR mit steigendem Epoxidanteil nicht proportional an. Dies deutet darauf hin, dass es sich hier nicht nur um einen Querschnittsflächeneffekt handelt, sondern die WVTR wesentlich auch von der Morphologie beeinflusst wird. Für V1 ist mikroskopisch nachgewiesen, dass die Hartphase dispers vorliegt. Insofern bilden sich keine Permeationskanäle im IPN, so dass die WVTR nahe der der Elastomerphase ist.

Für die Beispiele 3 und 6 ist allerdings mikroskopisch und über den Schertest nachgewiesen, dass sich ein verbundenes Nanopartikelnetzwerk ausbildet, also Permeationskanäle existieren. Dennoch steigt die WVTR nicht proportional mit dem Hartphasenanteil. So wäre etwa für Beispiel 6 eine WVTR von nahezu 60 bei proportionaler Steigerung zu erwarten.

Dies kann mit der besonderen Struktur eines verbundenen Nanopartikelnetzwerks erklärt werden: Die Nanopartikel sind nahezu punktförmig miteinander verbunden. Dadurch verringert sich der Permeationsquerschnitt drastisch und dies vielfach innerhalb eines Permeationskanals, so dass die WVTR trotz steigenden Hartphasenanteils gering gehalten wird. Erst bei der teilweisen Ausbildung einer gröberen bikontinuierlichen Morphologie in Beispiel 8 steigt die WVTR stark an, da hiermit Permeationskanäle mit deutlich gleichförmigerem Querschnitt geschaffen werden.

Die erfindungsgemäßen Haftklebemassen eigenen sich also besonders zur Versiegelung von der Verpackung beziehungsweise der Verkapselung von wassersensitiven Materialien.

### Ergebnisse des Zugversuches:

Es wurden Spannungs-Dehnungs-Kurven für die Beispiele 1, 3, 6 und 7 aufgenommen.

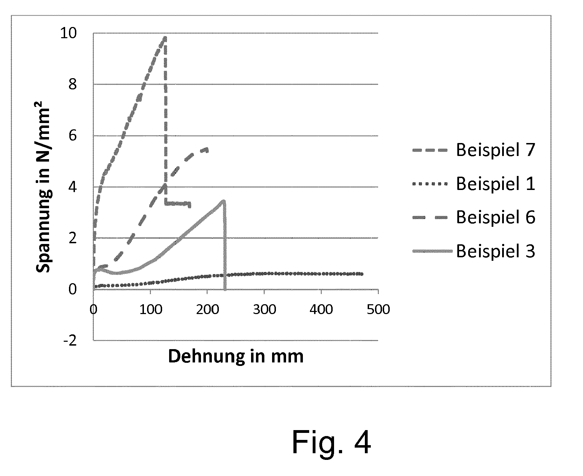

Am Verlauf der Graphen (Figur 4) lässt sich abschätzen, dass für die untersuchten Systeme erst oberhalb von 10 % Epoxidanteil kontinuierliche Strukturen aus verbundenen Epoxid-Nanopartikeln vorliegen, da dann ein hoher Modul im linearelastischen Bereich der Dehnung (bis etwa 3 mm) auftritt. Auch im weiteren Verlauf zeigen die Beispiele 3, 6 und 7 einen deutlich höheren Modul als Beispiel 1. Die geringe Anfangssteigung in Beispiel 1 deutet auf das Vorliegen einer im Wesentlichen dispersen Phase des Epoxids hin, welche keine nennenswerte Modulerhöhung bewirkt.

## Patentansprüche

1. Haftklebemasse, umfassend
mindestens zwei jeweils eine Phase bildende Bestandteile, aus denen durch insbesondere vernetzende Aufbaureaktion ein IPN mit mindestens zwei Phasen entsteht,
wobei die erste Phase (Elastomerphase) zumindest eine Erweichungstemperatur nach DSC von kleiner 23 °C und die zweite Phase nach der Aufbaureaktion eine Erweichungstemperatur nach DSC von größer 23 °C aufweist,
wobei die zweite Phase nach der Aufbaureaktion die Morphologie eines verbundenen Nanopartikelnetzwerks aufweist.

2. Haftklebemasse nach Anspruch 1,
**dadurch gekennzeichnet, dass**
das IPN ein Semi-IPN ist, bei der die erste Phase, die Elastomerphase, nicht vernetzt, insbesondere nicht kovalent vernetzt vorliegt.

3. Haftklebemasse nach Anspruch 1,
**dadurch gekennzeichnet, dass**
die Elastomerphase physikalisch wie durch Domänenbildung bei Blockcopolymeren und/oder koordinativ wie durch Koordination von Säuregruppen an Metallchelaten vernetzt ist.

4. Haftklebemasse nach Anspruch 1 oder 3,
**dadurch gekennzeichnet, dass**
das IPN sequenziell entsteht, so dass die Elastomerphase vor der zweiten Phase vernetzt wird.

5. Haftklebemasse nach zumindest einem der Ansprüche 1 bis 4,
**dadurch gekennzeichnet, dass**
als Elastomere Acrylate und/oder Methacrylate, Polyurethane, Naturkautschuke, Synthesekautschuke wie statistisch copolymerisierte Styrol-Butadien-Kautschuke (SBR), Butadien-Kautschuke (BR), synthetische Polyisoprene (IR), Butyl-Kautschuke (IIR), halogenierte Butyl-Kautschuke (XIIR), Acrylat-Kautschuke (ACM), Ethylenvinylacetat-Copolymere (EVA) oder Polyurethane und/oder deren Verschnitten, Styrolblockcopolymere mit einem Elastomerblock aus ungesättigten oder teilweise oder vollständig hydrierten Polydienblöcken (Polybutadien, Polyisopren, Poly(iso)butylen, Copolymeren aus diesen), Polyolefine, Fluorpolymere und/oder Silikone eingesetzt werden.

6. Haftklebemasse nach zumindest einem der vorhergehenden Ansprüche,
**dadurch gekennzeichnet, dass**
als Elastomere Blockcopolymere, insbesondere Vinylaromaten-Blockcopolymere eingesetzt werden.

7. Haftklebemasse nach zumindest einem der vorhergehenden Ansprüche,
**dadurch gekennzeichnet, dass**
für die zweite Phase als Reaktivkomponenten Epoxide, Polyester, Polyether, Polyurethane, Phenolharz-, Kresol oder Novolak basierte Polymere, Polysulfide oder Acrylpolymere (Acryl, Methacryl) eingesetzt werden.

8. Haftklebemasse nach zumindest einem der vorhergehenden Ansprüche,
**dadurch gekennzeichnet, dass**
die Aufbaureaktion kationisch oder mittels eines kontrollierten radikalischen Mechanismus wie RAFT, ATRP, NMRP erfolgt.

9. Haftklebemasse nach zumindest einem der vorhergehenden Ansprüche,
**dadurch gekennzeichnet, dass**
das Massenverhältnis von Elastomerphase zu Hartphase zwischen 85:15 bis 50:50 liegt, vorzugsweise zwischen 80:20 bis 60:40 oder vorzugsweise 85:15 bis 80:20 oder vorzugsweise zwischen 85:15 bis 65:35, insbesondere zwischen 80:20 bis 70:30 liegt.

10. Haftklebemasse nach zumindest einem der vorhergehenden Ansprüche,
**dadurch gekennzeichnet, dass**
die Haftklebemasse zumindest eine Sorte eines vorzugsweise zumindest teilhydrierten Klebharzes enthält, vorzugsweise solche, die mit der Elastomerkomponente beziehungsweise, sofern ein aus Hart- und Weichblöcken aufgebautes Copolymer eingesetzt wird, hauptsächlich mit dem Weichblock verträglich sind (Weichharze).

11. Haftklebemasse nach zumindest einem der vorhergehenden Ansprüche,
**dadurch gekennzeichnet, dass**
die Haftklebemasse im sichtbaren Licht des Spektrums (Wellenlängenbereich von etwa 400 nm bis 800 nm) transparent ist.

12. Haftklebemasse nach zumindest einem der vorhergehenden Ansprüche,
**dadurch gekennzeichnet, dass**
die Haftklebemasse einen Haze kleiner 5,0 %, bevorzugt kleiner 2,5 % zeigt.

13. Klebeband, enthaltend eine Schicht einer Haftklebemasse nach zumindest einem der vorhergehenden Ansprüche oder bestehend aus einer Schicht einer Haftklebemasse nach zumindest einem der vorhergehenden Ansprüche.

14. Klebeband,
**dadurch gekennzeichnet, dass**
auf einen Träger zumindest einseitig eine Schicht einer Haftklebemasse nach zumindest einem der vorhergehenden Ansprüche aufgebracht ist oder
auf einen Träger beidseitig eine Schicht einer Haftklebemasse nach zumindest einem der vorhergehenden Ansprüche aufgebracht ist.

15. Klebeband nach zumindest einem der Ansprüche 13 oder 14,
**dadurch gekennzeichnet, dass**
die Dicke der Haftklebemasse zwischen 1 µm und 2000 µm, bevorzugt zwischen 5 µm und 500 µm und besonders bevorzugt zwischen etwa 12 µm und 250 µm liegt.

16. Verwendung einer Haftklebemasse oder eines mit der Haftklebemasse gebildeten ein- oder doppelseitig klebenden Klebebands nach zumindest einem der vorhergehenden Ansprüche zur Kapselung einer (opto-)elektronischen Anordnung.

17. Verwendung einer Haftklebemasse oder eines mit der Haftklebemasse gebildeten ein- oder doppelseitig klebenden Klebebands nach zumindest einem der vorhergehenden Ansprüche in strukturellen Verklebungen.

18. Verfahren zur Herstellung einer Haftklebemasse insbesondere gemäß einem der vorherigen Ansprüche, **gekennzeichnet, durch** folgende Schritte:
1) Herstellung einer bevorzugt homogenen Mischung aus zumindest einem Elastomer, zumindest einer Reaktivkomponente (Reaktivharz/Monomer) und optional einem Klebharz, bei der der Massenanteil der Reaktivkomponente kleiner oder gleich (nicht größer) ist als die Summe des Elastomers und des optionalen Klebharzes
2) Starten der Aufbaureaktion des Reaktivharzes/Monomers, wobei aus dem Reaktivharz/Monomer disperse Nanopartikeln aufgebaut werden, die sich zu einem Netzwerk aus Nanopartikeln innerhalb der Elastomerphase verbinden.

19. Verfahren zur Herstellung einer Haftklebemasse nach Anspruch 18,
**dadurch gekennzeichnet, dass**
die Aufbaureaktion eine Vernetzungsreaktion, eine Polymerisation oder eine ein-, zwei- oder dreidimensionale Kettenwachstumsreaktion ist.
